# EUROPEAN PATENT APPLICATION

(11) **EP 4 580 367 A2**
(43) Date of publication of application: **02.07.2025**
(21) Application number: 24223538.0
(22) Date of filing: 27.12.2024
(51) Int. Cl.: H10K 59/122, H10K 59/80

(54) **DISPLAY DEVICE AND HEAD MOUNTED DISPLAY DEVICE INCLUDING THE SAME**

(30) Priority: 27.12.2023 KR 20230193376
(71) Applicant: Samsung Display Co., Ltd., Yongin-si, Gyeonggi-do 17113 (KR)
(72) Inventor: LEE, Hyoung Sub, Yongin-si (KR); KANG, Dong Yoon, Yongin-si (KR); KIM, Seung Hun, Yongin-si (KR); YOO, Hee Yeon, Yongin-si (KR)
(74) Representative: Marks & Clerk LLP

(57) **Abstract**

A display device includes: a substrate including a display area, a non-display area around the display area, and a plurality of transistors; a dam structure in the non-display area; a light emitting element layer including a plurality of light emitting elements in the display area; an encapsulation layer on the light emitting element layer; and a cover layer on the encapsulation layer. The dam structure includes: a first dam including a plurality of first dam patterns spaced from each other; and a second dam including a plurality of second dam patterns spaced from each other. A distance between the second dam and the display area is greater than a distance between the first dam and the display area.

## Description

### BACKGROUND

### 1. Field

Aspects of one or more embodiments of the present disclosure relate to a display device, and a head mounted display device including the display device.

### 2. Description of the Related Art

A head mounted display device (HMD) is an image display device that is worn on a user's head in the form of glasses or a helmet to form a focus at a close distance in front of the user's eyes. The head mounted display device may implement virtual reality (VR) or augmented reality (AR).

The head mounted display device magnifies an image displayed on a small display device by using a plurality of lenses, and displays the magnified image. Therefore, the display device applied to the head mounted display device may provide high-resolution images, for example, such as images with a resolution of 3000 PPI (Pixels Per Inch) or higher. As such, an organic light emitting diode on silicon (OLEDoS), which is a high-resolution small organic light emitting display device, is used as the display device that is applied to the head mounted display device. The OLEDoS is an image display device in which an organic light emitting diode (OLED) is disposed on a semiconductor wafer substrate on which a complementary metal oxide semiconductor (CMOS) is disposed.

The above information disclosed in this Background section is for enhancement of understanding of the background of the present disclosure, and therefore, it may contain information that does not constitute prior art.

### SUMMARY

Embodiments of the present disclosure may be directed to a display device including dams formed of patterns that are spaced apart from each other.

Embodiments of the present disclosure may be directed to a display device capable of controlling an edge shape of an organic encapsulation layer.

However, the aspects and features of the present disclosure are not limited to those set forth herein. The above and other aspects and features of the present disclosure will become more apparent to those having ordinary skill in the art from the detailed description of the present disclosure given below with reference to the accompanying drawings.

According to one or more embodiments of the present disclosure, a display device includes: a substrate including a display area, a non-display area around the display area, and a plurality of transistors; a dam structure in the non-display area; a light emitting element layer including a plurality of light emitting elements in the display area; an encapsulation layer on the light emitting element layer; and a cover layer on the encapsulation layer. The dam structure includes: a first dam including a plurality of first dam patterns spaced from each other; and a second dam including a plurality of second dam patterns spaced from each other. A distance between the second dam and the display area is greater than a distance between the first dam and the display area.

In an embodiment, the encapsulation layer may include: a first inorganic encapsulation layer extending beyond the second dam in the display area and the non-display area; an organic encapsulation layer on the first inorganic encapsulation layer, and covering the first dam without covering the second dam; and a second inorganic encapsulation layer on the organic encapsulation layer and the first inorganic encapsulation layer.

In an embodiment, the first inorganic encapsulation layer and the second inorganic encapsulation layer may be in direct contact with each other outside the second dam.

In an embodiment, an interval between the first dam patterns that are spaced from each other may be 100 µm or less.

In an embodiment, a first dam pattern of the first dam patterns and a second dam pattern of the second dam patterns may be located side by side with each other.

In an embodiment, the display area may have a curved diagonal edge, the first dam may include a plurality of third dam patterns having lateral sides that are curved to correspond to the curved diagonal edge of the display area, and the second dam may include a plurality of fourth dam patterns having lateral sides that are curved to correspond to the curved diagonal edge of the display area.

In an embodiment, the first dam patterns and the second dam patterns may be located alternately with each other, and a second dam pattern of the second dam patterns may be located side by side with an area between adjacent first dam patterns of the first dam patterns.

In an embodiment, the display device may further include a plurality of pads in the non-display area, and the pads may be located on an outside of the dam structure without overlapping with the encapsulation layer.

According to one or more embodiments of the present disclosure, a display device includes: a substrate including a display area, a non-display area around the display area, and a plurality of transistors; a first insulating film on the substrate; a pixel defining film on the first insulating film in the display area; a plurality of light emitting elements corresponding to a plurality of openings in the pixel defining film, respectively; a dam structure in the non-display area, and including a plurality of dams having a trench shape penetrating the pixel defining film; an encapsulation layer on the light emitting elements in the display area, and covering at least a portion of the plurality of dams; and a cover layer on the encapsulation layer. The dam structure includes an innermost dam that is adjacent to the display area, and an outermost dam outside the innermost dam. The encapsulation layer includes an organic encapsulation layer covering at least the innermost dam without overlapping with the outermost dam from among the plurality of dams, and covering the light emitting elements.

In an embodiment, the plurality of dams may have the same depth as each other.

In an embodiment, the display device may further include a second insulating film between the pixel defining film and the first insulating film, and each of the plurality of dams may penetrate the pixel defining film and the second insulating film.

In an embodiment, the display device may further include a third insulating film between the pixel defining film and the second insulating film, and each of the plurality of dams may penetrate the pixel defining film, the third insulating film, and the second insulating film.

In an embodiment, a depth of the outermost dam among the plurality of dams may be greater than a depth of the innermost dam among the plurality of dams.

In an embodiment, the display device may further include a second insulating film and a third insulating film between the pixel defining film and the first insulating film. The innermost dam may penetrate the pixel defining film, and the outermost dam may penetrate the pixel defining film, the second insulating film, and the third insulating film.

In an embodiment, the outermost dam may include a recessed portion of a top surface of the first insulating film.

In an embodiment, the display device may further include a second insulating film and a third insulating film between the pixel defining film and the first insulating film. The plurality of dams may penetrate the pixel defining film, the second insulating film, and the third insulating film, and may have widths that increase in a downward direction.

In an embodiment, a width of a portion in the plurality of dams penetrating the pixel defining film may be smaller than a width of a portion in the plurality of dams penetrating the second insulating film and the third insulating film.

In an embodiment, the plurality of dams may include a recessed portion of a top surface of the first insulating film, and a width of a portion in the plurality of dams penetrating the pixel defining film, the second insulating film, and the third insulating film may be smaller than a width of a portion in the plurality of dams including the recessed portion of the top surface of the first insulating film.

In an embodiment, a width of a portion in the plurality of dams penetrating the second insulating film and the third insulating film may be smaller than the width of the portion in the plurality of dams including the recessed portion of the first insulating film.

In an embodiment, the encapsulation layer may include a first inorganic encapsulation layer and a second inorganic encapsulation layer stacked on each other with the organic encapsulation layer interposed therebetween, and the first inorganic encapsulation layer and the second inorganic encapsulation layer may be in direct contact with each other outside the outermost dam of the dam structure.

According to one or more embodiments of the present disclosure, a head mounted display device includes: a frame configured to be mounted on a user's body to correspond to left and right eyes of the user; a plurality of display devices in the frame; and an eyepiece on each of the plurality of display devices. Each of the display devices includes: a substrate including a display area, a non-display area around the display area, and a plurality of transistors; a dam structure in the non-display area; a light emitting element layer including a plurality of light emitting elements in the display area; an encapsulation layer on the light emitting element layer; and a cover layer on the encapsulation layer. The dam structure includes: a first dam including a plurality of first dam patterns spaced from each other; and a second dam including a plurality of second dam patterns spaced from each other, the second dam having a trench shape and located at a greater distance from the display area than the first dam. The encapsulation layer includes an organic encapsulation layer covering the first dam without overlapping with the second dam, and covering the light emitting elements.

In an embodiment, the first dam and the second dam may have the same depth as each other.

In an embodiment, a depth of the second dam may be greater than a depth of the first dam.

At least some of the above and other features of the invention are set out in the claims.

According to some embodiments of the present disclosure, the display device may include dams formed of dam patterns that are spaced apart from each other to control the flow of an organic material to prevent or substantially prevent bending of the edge shape of the organic encapsulation layer. Therefore, the display device may improve a luminance and a light emission efficiency by lowering the thickness of the organic encapsulation layer, and may secure a product reliability by controlling the edge shape of the organic encapsulation layer.

However, the aspects and features of the present disclosure are not limited to those described above, and various other aspects and features are incorporated herein.

### BRIEF DESCRIPTION OF THE DRAWINGS

The above and other aspects and features of the present disclosure will be more clearly understood from the following detailed description of the illustrative, nonlimiting embodiments with reference to the accompanying drawings, in which:
FIG. 1 is an exploded perspective view of a display device according to an embodiment;
FIG. 2 is a block diagram illustrating a display device according to an embodiment;
FIG. 3 is an equivalent circuit diagram of a sub-pixel according to an embodiment;
FIG. 4 is a diagram showing a display panel according to an embodiment;
FIG. 5 is a plan view showing first electrodes and emission areas of a plurality of pixels disposed in a display area of FIG. 4, and a pixel defining film;
FIG. 6 is a plan view showing first electrodes and emission areas of a plurality of sub-pixels, and a pixel defining film according to another embodiment;
FIG. 7 is a schematic cross-sectional view taken along the line A-A' of FIG. 5;
FIG. 8 is an enlarged view showing the area X of FIG. 4;
FIG. 9 is a schematic cross-sectional view taken along the line B-B' of FIG. 8;
FIG. 10 is an enlarged view showing the area Y of FIG. 4;
FIG. 11 is a schematic cross-sectional view taken along the line C-C' of FIG. 10;
FIGS. 12 and 13 are plan views illustrating a schematic disposition of an encapsulation layer and dam structures of a display device according to an embodiment;
FIG. 14 is a plan view illustrating a schematic disposition of an encapsulation layer and dam structures of a display device according to another embodiment;
FIGS. 15 and 16 are schematic cross-sectional views illustrating a portion of a display device in which a dam structure is disposed according to one or more embodiments;
FIG. 17 is a schematic cross-sectional view illustrating a portion of a display device in which a dam structure is disposed according to another embodiment;
FIG. 18 is a cross-sectional view showing dams in more detail of the display device of FIG. 17;
FIG. 19 is a schematic cross-sectional view showing the structure of dams in a display device according to another embodiment;
FIGS. 20-22 are schematic cross-sectional views of dams of a display device according to one or more embodiments;
FIG. 23 is a perspective view illustrating a head mounted display device according to an embodiment;
FIG. 24 is an exploded perspective view showing an example of the head mounted display device of FIG. 23; and
FIG. 25 is a perspective view illustrating a head mounted display device according to an embodiment.

### DETAILED DESCRIPTION

Aspects and features of embodiments of the present disclosure and methods of accomplishing the same may be understood more readily by reference to the detailed description of embodiments and the accompanying drawings. Hereinafter, embodiments will be described in more detail with reference to the accompanying drawings. The described embodiments, however, may be embodied in various different forms, and should not be construed as being limited to only the illustrated embodiments herein. Rather, these embodiments are provided as examples so that the present disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure might not be described.

Unless otherwise noted, like reference numerals, characters, or combinations thereof denote like elements throughout the attached drawings and the written description, and thus, descriptions thereof will not be repeated. Further, parts not related to the description of one or more embodiments might not be shown to make the description clear.

In the drawings, the relative sizes of elements, layers, and regions may be exaggerated for clarity. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result, for example, of manufacturing techniques and/or tolerances, are to be expected. Further, specific structural or functional descriptions disclosed herein are merely illustrative for the purpose of describing embodiments according to the present disclosure. Thus, embodiments disclosed herein should not be construed as limited to the particular illustrated shapes of regions, but are to include deviations in shapes that result from, for instance, manufacturing.

For example, an implanted region illustrated as a rectangle may have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the drawings are schematic in nature and their shapes are not intended to illustrate the actual shape of a region of a device and are not intended to be limiting. Additionally, as those skilled in the art would realize, the described embodiments may be modified in various different ways, all without departing from the scope of the present disclosure.

In the detailed description, for the purposes of explanation, numerous specific details are set forth to provide a thorough understanding of various embodiments. It is apparent, however, that various embodiments may be practiced without these specific details or with one or more equivalent arrangements. In other instances, well-known structures and devices are shown in block diagram form to avoid unnecessarily obscuring various embodiments.

Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, in this specification, the phrase "on a plane," or "in a plan view," means viewing a target portion from the top, and the phrase "on a cross-section" means viewing a cross-section formed by vertically cutting a target portion from the side.

It will be understood that when an element, layer, region, or component is referred to as being "formed on," "on," "connected to," or "coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. For example, when a layer, region, or component is referred to as being "electrically connected" or "electrically coupled" to another layer, region, or component, it can be directly electrically connected or coupled to the other layer, region, and/or component or intervening layers, regions, or components may be present. However, "directly connected/directly coupled" refers to one component directly connecting or coupling another component without an intermediate component. Meanwhile, other expressions describing relationships between components such as "between," "immediately between" or "adjacent to" and "directly adjacent to" may be construed similarly. In addition, it will also be understood that when an element or layer is referred to as being "between" two elements or layers, it can be the only element or layer between the two elements or layers, or one or more intervening elements or layers may also be present.

For the purposes of the present disclosure, expressions such as "at least one of," "one of," and "selected from," when preceding a list of elements, modify the entire list of elements and do not modify the individual elements of the list. For example, "at least one of X, Y, and Z," "at least one of X, Y, or Z," and "at least one selected from the group consisting of X, Y, and Z" may be construed as X only, Y only, Z only, any combination of two or more of X, Y, and Z, such as, for instance, XYZ, XYY, XZ, YZ, and ZZ, or any variation thereof. Similarly, the expression such as "at least one of A and/or B" may include A, B, or A and B. As used herein, the term "and/or" includes any and all combinations of one or more of the associated listed items. For example, the expression such as "A and/or B" may include A, B, or A and B. Further, the use of "may" when describing embodiments of the present disclosure refers to "one or more embodiments of the present disclosure".

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing particular embodiments only and is not intended to be limiting of the present disclosure. As used herein, the singular forms "a" and "an" are intended to include the plural forms as well, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

As used herein, the term "substantially," "about," "approximately," and similar terms are used as terms of approximation and not as terms of degree, and are intended to account for the inherent deviations in measured or calculated values that would be recognized by those of ordinary skill in the art. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

When one or more embodiments may be implemented differently, a specific process order may be performed differently from the described order. For example, two consecutively described processes may be performed substantially at the same time or performed in an order opposite to the described order.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, for example, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein.

The electronic or electric devices and/or any other relevant devices or components according to one or more embodiments of the present disclosure described herein may be implemented utilizing any suitable hardware, firmware (e.g., an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate.

Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning for example consistent with their meaning in the context of the relevant art and/or the present specification, and should not be interpreted in an idealized or overly formal sense, unless expressly so defined herein.

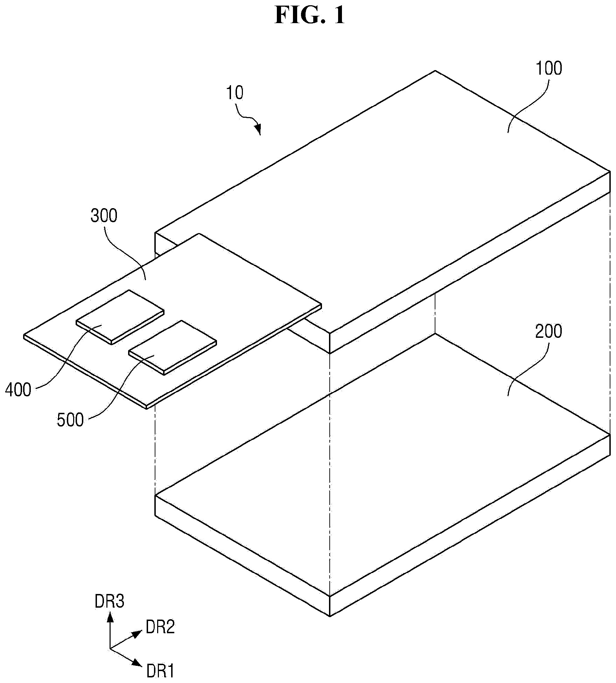

FIG. 1 is an exploded perspective view of a display device according to an embodiment.

Referring to FIG. 1, a display device 10 according to an embodiment is a device for displaying a moving image or a still image. The display device 10 according to an embodiment may be applied to various suitable portable electronic devices, such as a mobile phone, a smartphone, a tablet personal computer, a mobile communication terminal, an electronic organizer, an electronic book, a portable multimedia player (PMP), a navigation system, an ultra mobile PC (UMPC), or the like. For example, the display device 10 may be applied as a display unit of a television, a laptop, a monitor, a billboard, or an Internet-of-Things (IoT) device. As another example, the display device 10 may be applied to a smart watch, a watch phone, a head mounted display device (HMD) for implementing virtual reality and augmented reality, and the like.

The display device 10 according to an embodiment includes a display panel 100, a heat dissipation layer 200, a circuit board 300, a timing control circuit 400, and a power supply circuit 500.

The display panel 100 may have a planar shape similar to a quadrilateral shape. For example, the display panel 100 may have a short side extending in a first direction DR1 and a long side extending in a second direction DR2 crossing or intersecting the first direction DR1. In the display panel 100, a corner where a short side extending in the first direction DR1 and a long side extending in the second direction DR2 meet each other may be right-angled or rounded with a curvature (e.g., a predetermined curvature). The planar shape of the display panel 100 is not limited to the quadrilateral shape, and may have other suitable shapes, such as those similar to another polygonal shape, a circular shape, or an elliptical shape. The planar shape of the display device 10 may conform to the planar shape of the display panel 100, but the present disclosure is not limited thereto.

The heat dissipation layer 200 may overlap with the display panel 100 in a third direction DR3, which is the thickness direction of the display panel 100. The heat dissipation layer 200 may be disposed on one surface of the display panel 100, for example, such as on the rear surface of the display panel 100. The heat dissipation layer 200 serves to dissipate heat generated from the display panel 100. The heat dissipation layer 200 may include a metal layer having a high thermal conductivity, such as graphite, silver (Ag), copper (Cu), or aluminium (Al).

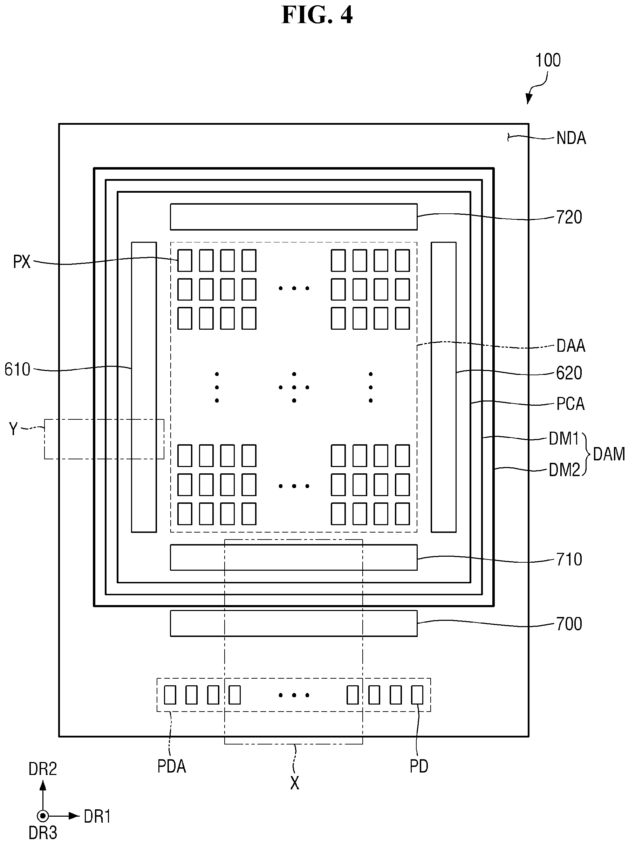

The circuit board 300 may be electrically connected to a plurality of pads PD (e.g., see FIG. 4) of a pad portion PDA of the display panel 100 by using a conductive adhesive member, such as an anisotropic conductive film. The circuit board 300 may be a flexible printed circuit board having a flexible material, or a flexible film. Although the circuit board 300 is illustrated in FIG. 1 as being unfolded, the circuit board 300 may be bent. In this case, one end of the circuit board 300 may be disposed on the rear surface of the display panel 100 and/or the rear surface of the heat dissipation layer 200. The one end of the circuit board 300 may be an opposite end of the other end of the circuit board 300 that is connected to the plurality of pads PD (e.g., see FIG. 4) of the pad portion PDA of the display panel 100 by using the conductive adhesive member.

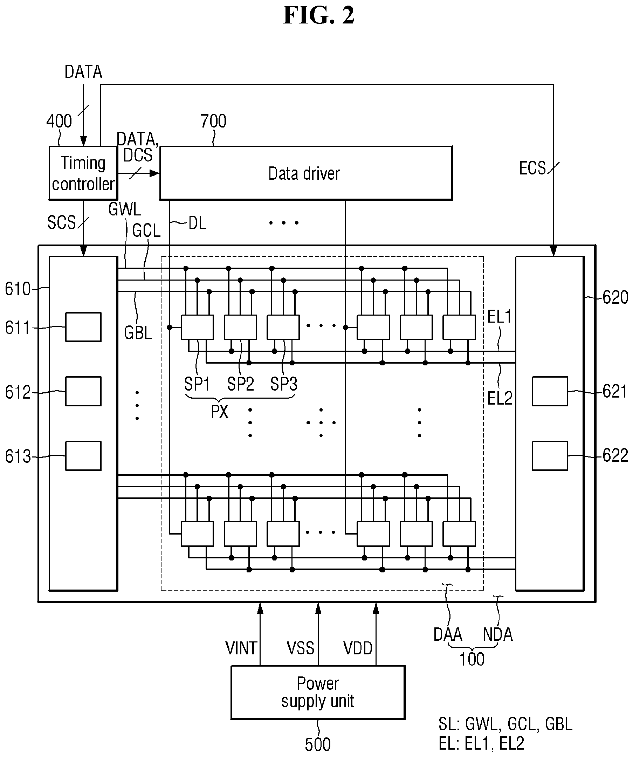

The timing control circuit 400 may receive digital video data and timing signals input from the outside. The timing control circuit 400 may generate a scan timing control signal SCS (e.g., see FIG. 2), an emission timing control signal ECS, and a data timing control signal DCS for controlling the display panel 100 in response to the timing signals. The timing control circuit 400 may output the scan timing control signal SCS to a scan driver 610 (e.g., see FIG. 2), and output the emission timing control signal ECS to an emission driver 620. The timing control circuit 400 may output the digital video data DATA and the data timing control signal DCS to a data driver 700 (e.g., see FIG. 2).

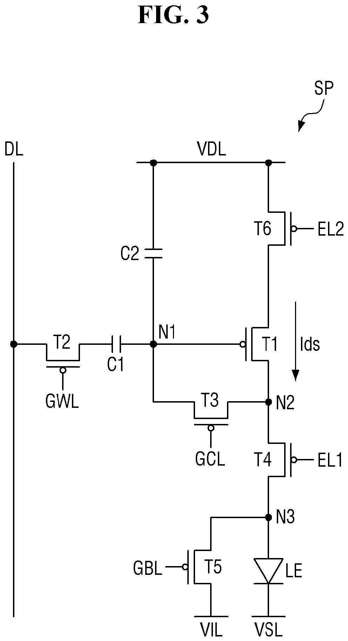

The power supply circuit 500 may generate a plurality of panel driving voltages according to a power voltage from the outside. For example, the power supply circuit 500 may generate a first driving voltage VSS (e.g., see FIG. 2), a second driving voltage VDD, and a third driving voltage VINT, and supply them to the display panel 100. The first driving voltage VSS, the second driving voltage VDD, and the third driving voltage VINT will be described in more detail below with reference to FIG. 3.

Each of the timing control circuit 400 and the power supply circuit 500 may be formed as an integrated circuit (IC), and attached to one surface of the circuit board 300. In this case, the scan timing control signal SCS, the emission timing control signal ECS, digital video data DATA, and the data timing control signal DCS of the timing control circuit 400 may be supplied to the display panel 100 through the circuit board 300. Further, the first driving voltage VSS, the second driving voltage VDD, and the third driving voltage VINT of the power supply circuit 500 may be supplied to the display panel 100 through the circuit board 300.

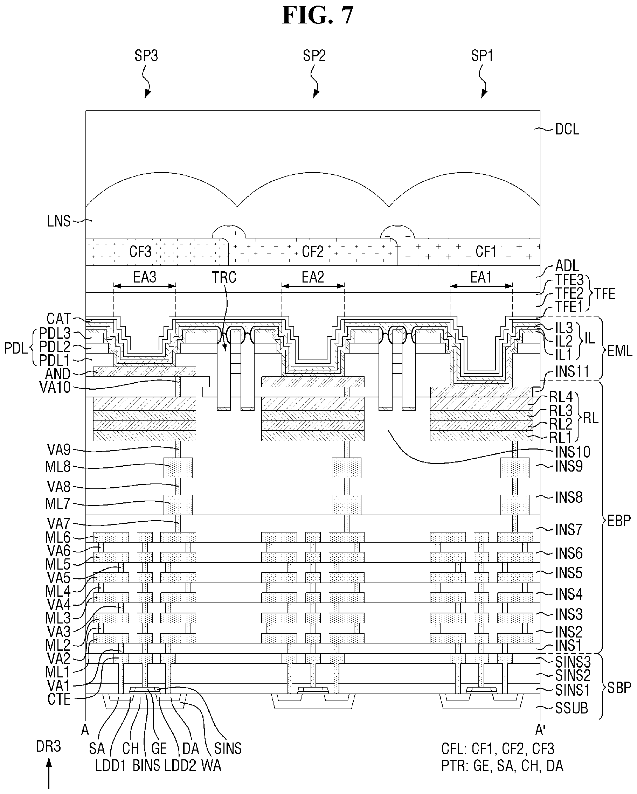

As another example, each of the timing control circuit 400 and the power supply circuit 500 may be disposed in a non-display area NDA (e.g., see FIG. 2) of the display panel 100, similarly to the scan driver 610, the emission driver 620, and the data driver 700. In this case, the timing control circuit 400 may include a plurality of timing transistors, and the power supply circuit 500 may include a plurality of power transistors. The plurality of timing transistors and the plurality of power transistors may be formed on a semiconductor substrate SSUB (e.g., see FIG. 7) through a semiconductor process. For example, the plurality of timing transistors and the plurality of power transistors may be formed of CMOS. Each of the timing control circuit 400 and the power supply circuit 500 may be disposed between the data driver 700 and the pad portion PDA (e.g., see FIG. 4).

FIG. 2 is a block diagram illustrating a display device according to an embodiment.

Referring to FIG. 2, the display panel 100 may include a display area DAA, and the non-display area NDA disposed around the display area DAA. In the display area DAA, a plurality of pixels PX are disposed to emit light or display an image. In the non-display area NDA, light may not be emitted or an image may not be displayed.

The display panel 100 may include the plurality of pixels PX, a plurality of scan lines SL, a plurality of emission control lines EL, and a plurality of data lines DL that are disposed in the display area DAA.

The plurality of pixels PX may be arranged along the first and second directions DR1 and DR2. The plurality of pixels PX may be arranged in a matrix in the display area DAA. The plurality of scan lines SL and the plurality of emission control lines EL may extend in the first direction DR1, and may be arranged to be spaced apart from one another in the second direction DR2. The plurality of data lines DL may extend in the second direction DR2, may be arranged to be spaced apart from one another in the first direction DR1.

The plurality of scan lines SL may include a plurality of write scan lines GWL, a plurality of control scan lines GCL, and a plurality of bias scan lines GBL. The plurality of emission control lines EL include a plurality of first emission control lines EL1 and a plurality of second emission control lines EL2.

The plurality of pixels PX may include a plurality of sub-pixels SP1, SP2, and SP3. The plurality of sub-pixels SP1, SP2, and SP3 may include a plurality of pixel transistors as shown in FIG. 3. The plurality of pixel transistors may be formed through a semiconductor process to be disposed on the semiconductor substrate SSUB (e.g., see FIG. 7). For example, the plurality of pixel transistors may be formed of a complementary metal oxide semiconductor (CMOS).

Each of the plurality of sub-pixels SP1, SP2, and SP3 may be connected to any one write scan line GWL from among the plurality of write scan lines GWL, any one control scan line GCL from among the plurality of control scan lines GCL, any one bias scan line GBL from among the plurality of bias scan lines GBL, any one first emission control line EL1 from among the plurality of first emission control lines EL1, any one second emission control line EL2 from among the plurality of second emission control lines EL2, and any one data line DL from among the plurality of data lines DL. Each of the plurality of sub-pixels SP1, SP2, and SP3 may receive a data voltage of the corresponding data line DL in response to a write scan signal of the corresponding write scan line GWL, and emit light from the corresponding light emitting element according to the data voltage.

The display panel 100 may include the scan driver 610, the emission driver 620, and the data driver 700 that are disposed in the non-display area NDA.

The scan driver 610 includes a plurality of scan transistors, and the emission driver 620 includes a plurality of light emitting transistors. The plurality of scan transistors and the plurality of light emitting transistors may be formed on the semiconductor substrate SSUB (e.g., see FIG. 7) through a semiconductor process. For example, the plurality of scan transistors and the plurality of light emitting transistors may be formed of CMOS. Although FIG. 2 shows that the scan driver 610 is disposed on the left side of the display area DAA and the emission driver 620 is disposed on the right side of the display area DAA, the present disclosure is not limited thereto. For example, the scan driver 610 and the emission driver 620 may be disposed on both the left side and the right side of the display area DAA.

The scan driver 610 may include a write scan signal output unit (e.g., a write scan signal output circuit) 611, a control scan signal output unit (e.g., a control scan signal output circuit) 612, and a bias scan signal output unit (e.g., a bias scan signal output circuit) 613. Each of the write scan signal output unit 611, the control scan signal output unit 612, and the bias scan signal output unit 613 may receive the scan timing control signal SCS from the timing control circuit 400. The write scan signal output unit 611 may generate write scan signals according to the scan timing control signal SCS of the timing control circuit 400, and output the write scan signals sequentially to the write scan lines GWL. The control scan signal output unit 612 may generate control scan signals in response to the scan timing control signal SCS, and sequentially output the control scan signals to the control scan lines GCL. The bias scan signal output unit 613 may generate bias scan signals according to the scan timing control signal SCS, and output the bias scan signals sequentially to the bias scan lines GBL.

The emission driver 620 includes a first emission control driver 621 and a second emission control driver 622. Each of the first emission control driver 621 and the second emission control driver 622 may receive the emission timing control signal ECS from the timing control circuit 400. The first emission control driver 621 may generate first emission control signals according to the emission timing control signal ECS, and sequentially output the first emission control signals to the first emission control lines EL1. The second emission control driver 622 may generate second emission control signals according to the emission timing control signal ECS, and sequentially output the second emission control signals to the second emission control lines EL2.

The data driver 700 may include a plurality of data transistors, and the plurality of data transistors may be formed on the semiconductor substrate SSUB (e.g., see FIG. 7) through a semiconductor process. For example, the plurality of data transistors may be formed of CMOS.

The data driver 700 may receive the digital video data DATA and the data timing control signal DCS from the timing control circuit 400. The data driver 700 converts the digital video data DATA into analog data voltages according to the data timing control signal DCS, and outputs the analog data voltages to the data lines DL. In this case, the sub-pixels SP1, SP2, and SP3 are selected by the write scan signal of the scan driver 610, and data voltages may be supplied to the selected sub-pixels SP1, SP2, and SP3.

FIG. 3 is an equivalent circuit diagram of a sub-pixel according to an embodiment.

Referring to FIG. 3, the sub-pixel SP may be connected to the write scan line GWL, the control scan line GCL, the bias scan line GBL, the first emission control line EL1, the second emission control line EL2, and the data line DL. In addition, the sub-pixel SP may be connected to a first driving voltage line VSL to which the first driving voltage VSS corresponding to a low potential voltage is applied, a second driving voltage line VDL to which the second driving voltage VDD corresponding to a high potential voltage is applied, and a third driving voltage line VIL to which the third driving voltage VINT corresponding to an initialization voltage is applied. In other words, the first driving voltage line VSL may be a low potential voltage line, the second driving voltage line VDL may be a high potential voltage line, and the third driving voltage line VIL may be an initialization voltage line. In this case, the first driving voltage VSS may be lower than the third driving voltage VINT. The second driving voltage VDD may be higher than the third driving voltage VINT.

The sub-pixel SP includes a plurality of transistors T1 to T6, a light emitting element LE, a first capacitor C1, and a second capacitor C2.

The light emitting element LE emits light in response to a driving current Ids flowing through the channel of the first transistor T1. The emission amount of the light emitting element LE may be proportional to the driving current Ids. The light emitting element LE may be disposed between the fourth transistor T4 and the first driving voltage line VSL. The first electrode of the light emitting element LE may be connected to the drain electrode of the fourth transistor T4, and the second electrode of the light emitting element LE may be connected to the first driving voltage line VSL. The first electrode of the light emitting element LE may be an anode electrode, and the second electrode of the light emitting element LE may be a cathode electrode. The light emitting element LE may be an organic light emitting diode including the first electrode, the second electrode, and an organic light emitting layer disposed between the first electrode and the second electrode, but the present disclosure is not limited thereto. For example, the light emitting element LE may be an inorganic light emitting element including a first electrode, a second electrode, and an inorganic semiconductor disposed between the first electrode and the second electrode, in which case the light emitting element LE may be a micro light emitting diode.

The first transistor T1 may be a driving transistor that controls a source-drain current Ids (hereinafter referred to as the "driving current") flowing between the source electrode and the drain electrode thereof according to a voltage applied to the gate electrode thereof. The first transistor T1 includes a gate electrode connected to a first node N1, a source electrode connected to the drain electrode of the sixth transistor T6, and a drain electrode connected to a second node N2.

The second transistor T2 may be disposed between one electrode of the first capacitor C1 and the data line DL. The second transistor T2 is turned on by the write scan signal of the write scan line GWL to connect the one electrode of the first capacitor C1 to the data line DL. Accordingly, the data voltage of the data line DL may be applied to the one electrode of the first capacitor C1. The second transistor T2 includes a gate electrode connected to the write scan line GWL, a source electrode connected to the data line DL, and a drain electrode connected to the one electrode of the first capacitor C1.

The third transistor T3 may be disposed between the first node N1 and the second node N2. The third transistor T3 is turned on by the write control signal of the control scan line GCL to connect the first node N1 to the second node N2. As such, because the gate electrode and the source electrode of the first transistor T1 are connected to each other, the first transistor T1 may operate like a diode (e.g., may be diode-connected). The third transistor T3 includes a gate electrode connected to the control scan line GCL, a source electrode connected to the second node N2, and a drain electrode connected to the first node N1.

The fourth transistor T4 may be connected between the second node N2 and a third node N3. The fourth transistor T4 is turned on by the first emission control signal of the first emission control line EL1 to connect the second node N2 to the third node N3. Accordingly, the driving current of the first transistor T1 may be supplied to the light emitting element LE. The fourth transistor T4 includes a gate electrode connected to the first emission control line EL1, a source electrode connected to the second node N2, and a drain electrode connected to the third node N3.

The fifth transistor T5 may be disposed between the third node N3 and the third driving voltage line VIL. The fifth transistor T5 is turned on by the bias scan signal of the bias scan line GBL to connect the third node N3 to the third driving voltage line VIL. Accordingly, the third driving voltage VINT of the third driving voltage line VIL may be applied to the first electrode of the light emitting element LE. The fifth transistor T5 includes a gate electrode connected to the bias scan line GBL, a source electrode connected to the third node N3, and a drain electrode connected to the third driving voltage line VIL.

The sixth transistor T6 may be disposed between the source electrode of the first transistor T1 and the second driving voltage line VDL. The sixth transistor T6 is turned on by the second emission control signal of the second emission control line EL2 to connect the source electrode of the first transistor T1 to the second driving voltage line VDL. Accordingly, the second driving voltage VDD of the second driving voltage line VDL may be applied to the source electrode of the first transistor T1. The sixth transistor T6 includes a gate electrode connected to the second emission control line EL2, a source electrode connected to the second driving voltage line VDL, and a drain electrode connected to the source electrode of the first transistor T1.

The first capacitor C1 is formed between the first node N1 and the drain electrode of the second transistor T2. The first capacitor C1 includes one electrode connected to the drain electrode of the second transistor T2 and the other electrode connected to the first node N1.

The second capacitor C2 is formed between the gate electrode of the first transistor T1 and the second driving voltage line VDL. The second capacitor C2 includes one electrode connected to the gate electrode of the first transistor T1 and the other electrode connected to the second driving voltage line VDL.

The first node N1 is a junction between the gate electrode of the first transistor T1, the drain electrode of the third transistor T3, the other electrode of the first capacitor C1, and the one electrode of the second capacitor C2. The second node N2 is a junction between the drain electrode of the first transistor T1, the source electrode of the third transistor T3, and the source electrode of the fourth transistor T4. The third node N3 is a junction between the drain electrode of the fourth transistor T4, the source electrode of the fifth transistor T5, and the first electrode of the light emitting element LE.

Each of the first to sixth transistors T1 to T6 may be a metal-oxide-semiconductor field effect transistor (MOSFET). For example, each of the first to sixth transistors T1 to T6 may be a P-type MOSFET, but the present disclosure is not limited thereto. As another example, each of the first to sixth transistors T1 to T6 may be an N-type MOSFET. As another example, some of the first to sixth transistors T1 to T6 may be P-type MOSFETs, and each of the other remaining transistors may be an N-type MOSFET.

Although FIG. 3 shows that the sub-pixel SP includes the six transistors T1 to T6 and the two capacitors C1 and C2, the present disclosure is not limited to the equivalent circuit diagram of the sub-pixel SP shown in FIG. 3. For example, the number of the transistors and the number of the capacitors of the sub-pixel SP are not limited to the example shown in FIG. 3.

FIG. 4 is a diagram showing a display panel according to an embodiment.

Referring to FIG. 4, the display panel 100 according to an embodiment may include the plurality of pixels PX arranged in a matrix form in the display area DAA. The display panel 100 may include the scan driver 610, the emission driver 620, the data driver 700, a first distribution circuit 710, a second distribution circuit 720, the pad portion PDA, a power connection portion PCA, and a dam structure DAM that are disposed in the non-display area NDA. In addition, the display panel 100 may further include a static electricity protection portion, a moisture permeation prevention portion, and a crack prevention portion that are disposed outside the dam structure DAM.

The scan driver 610 may be disposed on a first side of the display area DAA, and the emission driver 620 may be disposed on a second side of the display area DAA. For example, the scan driver 610 may be disposed on one side of the display area DAA in the first direction DR1, and the emission driver 620 may be disposed on the other side of the display area DAA in the first direction DR1. In other words, the scan driver 610 may be disposed on the left side of the display area DAA, and the emission driver 620 may be disposed on the right side of the display area DAA. However, the present specification is not limited thereto, and the scan driver 610 and the emission driver 620 may be disposed on both the first side and the second side of the display area DAA.

The pad portion PDA may include the plurality of pads PD connected to pads or bumps of the circuit board 300 through a conductive adhesive member. The pad portion PDA may be disposed on a third side of the display area DAA. For example, the pad portion PDA may be disposed on one side of the display area DAA in the second direction DR2. In other words, the pad portion PDA may be disposed on the lower side of the display area DAA. The pad portion PDA may be disposed outside the data driver 700 in the second direction DR2. In other words, the pad portion PDA may be disposed closer to an edge of the display panel 100 than the data driver 700.

In some embodiments, the display panel 100 may further include inspection pads to check whether the display panel 100 operates normally. The inspection pads may be connected to a jig or a probe pin during an inspection process, or may be connected to a circuit board for inspection. The circuit board for inspection may be a printed circuit board made of a rigid material or a flexible printed circuit board made of a flexible material.

The first distribution circuit 710 distributes data voltages applied through the pad portion PDA to the plurality of data lines DL. For example, the first distribution circuit 710 may distribute the data voltages applied through one pad PD of the pad portion PDA to P data lines DL (where P is a positive integer of 2 or more), and as a result, the number of the plurality of pads PD may be reduced. The first distribution circuit 710 may be disposed on the third side of the display area DAA of the display panel 100. For example, the first distribution circuit 710 may be disposed on one side of the display area DAA in the second direction DR2. In other words, the first distribution circuit 710 may be disposed on the lower side of the display area DAA.

The second distribution circuit 720 distributes signals applied through the pad portion PDA to the scan driver 610, the emission driver 620, and the data lines DL. The second distribution circuit 720 may inspect the operation of each of the pixels PX in the display area DAA. The second distribution circuit 720 may be disposed on a fourth side of the display area DAA of the display panel 100. For example, the second distribution circuit 720 may be disposed on the other side of the display area DAA in the second direction DR2. In other words, the second distribution circuit 720 may be disposed on the upper side of the display area DAA. However, the present disclosure is not limited thereto, and the second distribution circuit 720 may be omitted as needed or desired.

The power connection portion PCA refers to the area in which the second electrode of the light emitting element LE (e.g., see FIG. 3) and the power connection electrode to which the first driving voltage VSS is applied are connected to each other, to apply the first driving voltage VSS to the second electrode of the light emitting element LE.

The power connection portion PCA may be disposed to surround (e.g., around a periphery of) the display area DAA. In addition, the power connection portion PCA may be disposed outside the scan driver 610, the emission driver 620, the first distribution circuit 710, and the second distribution circuit 720. For example, the power connection portion PCA may be disposed closer to an edge of the display panel 100 than the scan driver 610, the emission driver 620, the first distribution circuit 710, and the second distribution circuit 720. The power connection portion PCA may be disposed to surround the scan driver 610, the emission driver 620, the first distribution circuit 710, and the second distribution circuit 720. However, the present disclosure is not limited thereto, and the power connection portion PCA may overlap with at least one of the scan driver 610, the emission driver 620, the first distribution circuit 710, or the second distribution circuit 720 in the third direction DR3.

The dam structure DAM may be a structure for preventing or substantially preventing an organic encapsulation layer TFE2 of an encapsulation layer TFE (e.g., see FIG. 7) for encapsulating the light emitting elements LE (e.g., see FIG. 3) from overflowing to the pad portion PDA.

The dam structure DAM may be arranged to surround (e.g., around a periphery of) the display area DAA. In addition, the dam structure DAM may be disposed outside the scan driver 610, the emission driver 620, the first distribution circuit 710, and the second distribution circuit 720. For example, the dam structure DAM may be disposed closer to the edge of the display panel 100 than the scan driver 610, the emission driver 620, the first distribution circuit 710, and the second distribution circuit 720. The dam structure DAM may be disposed to surround the scan driver 610, the emission driver 620, the first distribution circuit 710, and the second distribution circuit 720. However, the present disclosure is not limited thereto, and the dam structure DAM may overlap with at least one of the scan driver 610, the emission driver 620, the first distribution circuit 710, or the second distribution circuit 720 in the third direction DR3.

In addition, the dam structure DAM may be disposed outside the power connection portion PCA. For example, the dam structure DAM may be disposed closer to the edge of the display panel 100 than the power connection portion PCA. The dam structure DAM may be disposed to surround (e.g., around a periphery of) the power connection portion PCA.

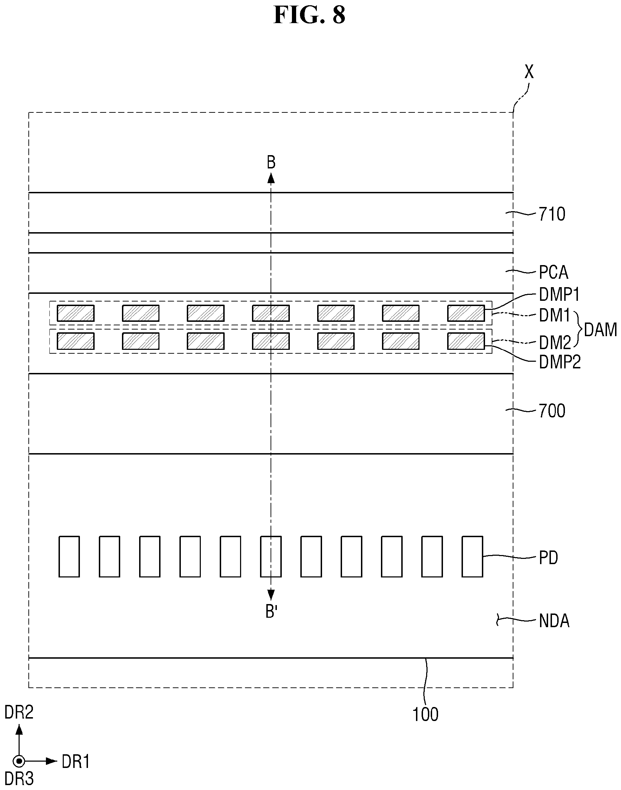

According to an embodiment, the dam structure DAM may include a first dam DM1 surrounding (e.g., around a periphery of) the display area DAA, and a second dam DM2 surrounding (e.g., around a periphery of) the first dam DM1. In the display device 10, because the dam structure DAM may be formed of one or more dams DM1 and DM2, an overflow of the encapsulation layer may be smoothly controlled. In addition, as will be described in more detail below, the dams DM1 and DM2 may include (e.g., may be made of) multiple dam patterns DMP1 and DMP2 (e.g., see FIG. 8), respectively, that are spaced apart from each other, and an edge of the encapsulation layer may be formed more smoothly to improve a product quality.

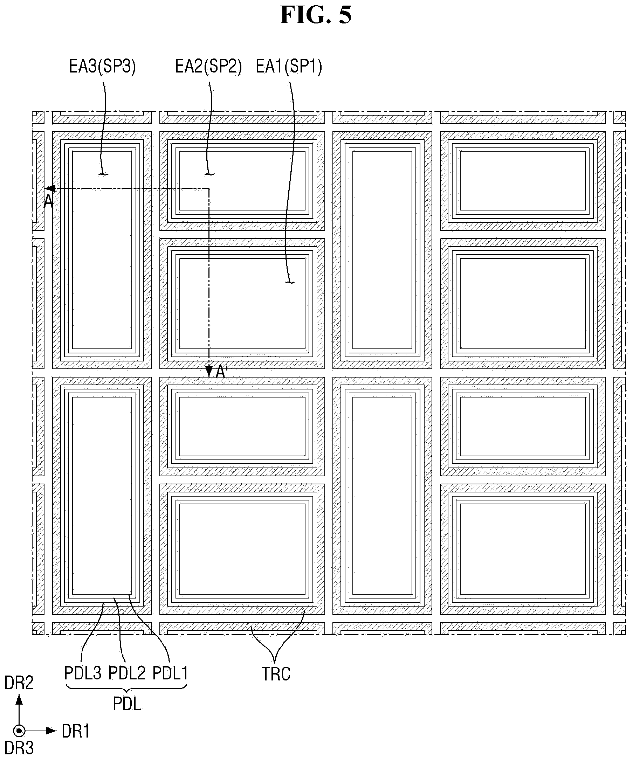

FIG. 5 is a plan view showing first electrodes and emission areas of a plurality of pixels disposed in a display area of FIG. 4, and a pixel defining film.

Referring to FIG. 5, each of the plurality of pixels PX may include a first sub-pixel SP1, a second sub-pixel SP2, and a third sub-pixel SP3. The first to third sub-pixels SP1, SP2, and SP3 may include emission areas EA1, EA2, and EA3, respectively. For example, the first sub-pixel SP1 may include the first emission area EA1, the second sub-pixel SP2 may include the second emission area EA2, and the third sub-pixel SP3 may include the third emission area EA3.

Each of the first emission area EA1, the second emission area EA2, and the third emission area EA3 may be an area defined by a pixel defining film PDL. For example, each of the first emission area EA1, the second emission area EA2, and the third emission area EA3 may be an area defined by a first pixel defining film PDL1.

The length of the third emission area EA3 in the first direction DR1 may be smaller than the length of the first emission area EA1 in the first direction DR1, and may be smaller than the length of the second emission area EA2 in the first direction DR1. The length of the first emission area EA1 in the first direction DR1 and the length of the second emission area EA2 in the first direction DR1 may be the same or substantially the same as each other.

In each of the plurality of pixels PX, the first emission area EA1 and the second emission area EA2 may be adjacent to each other in the second direction DR2. Further, the first emission area EA1 and the third emission area EA3 may be adjacent to each other in the first direction DR1. Further, the second emission area EA2 and the third emission area EA3 may be adjacent to each other in the first direction DR1. The area of the first emission area EA1, the area of the second emission area EA2, and the area of the third emission area EA3 may be different from each other.

The first emission area EA1 may emit light of a first color, the second emission area EA2 may emit light of a second color, and the third emission area EA3 may emit light of a third color. The light of the first color may be light of a red wavelength band, the light of the second color may be light of a green wavelength band, and the light of the third color may be light of a blue wavelength band. For example, the blue wavelength band may be a wavelength band of light having a main peak wavelength in the range of about 370 nm to about 460 nm, the green wavelength band may be a wavelength band of light having a main peak wavelength in the range of about 480 nm to about 560 nm, and the red wavelength band may be a wavelength band of light having a main peak wavelength in the range of about 600 nm to about 750 nm.

A first electrode AND of the light emitting element LE may have a rectangular shape in a plan view. The planar shape of the first electrode AND of the light emitting element LE may be different in the first sub-pixel SP1, the second sub-pixel SP2, and the third sub-pixel SP3. For example, the first electrode AND of the first sub-pixel SP1 and the first electrode AND of the second sub-pixel SP2 may have a rectangular planar shape having a long side extending in the first direction DR1 and a short side extending in the second direction DR2. The first electrode AND of the third sub-pixel SP3 may have a rectangular shape, in a plan view, having a short side extending in the first direction DR1 and a long side extending in the second direction DR2. The length of the first electrode AND of the third sub-pixel SP3 in the first direction DR1 may be shorter than the length of the first electrode AND of each of the first sub-pixel SP1 and the second sub-pixel SP2 in the second direction DR2. The length of the first electrode AND of the first sub-pixel SP1 in the second direction DR2 may be longer than the length of the first electrode AND of the second sub-pixel SP2 in the second direction DR2.

The first electrode AND of the light emitting element LE may be connected to a reflective electrode layer RL (e.g., see FIG. 7) through a tenth via VA10. The tenth via VA10 may overlap with the first pixel defining film PDL1, a second pixel defining film PDL2, and a third pixel defining film PDL3 in the third direction DR3.

At least one trench TRC may be a structure for cutting off at least one charge generation layer of a light emitting stack IL between neighboring (e.g., adjacent) emission areas EA1, EA2, and EA3. At least one trench TRC may be disposed between the first emission area EA1 and the second emission area EA2, between the first emission area EA1 and the third emission area EA3, and between the second emission area EA2 and the third emission area EA3. In more detail, at least one trench TRC may be disposed between the first electrode AND of the first sub-pixel SP1 and the first electrode AND of the second sub-pixel SP2, between the first electrode AND of the first sub-pixel SP1 and the first electrode AND of the third sub-pixel SP3, and between the first electrode AND of the second sub-pixel SP2 and the first electrode AND of the third sub-pixel SP3.

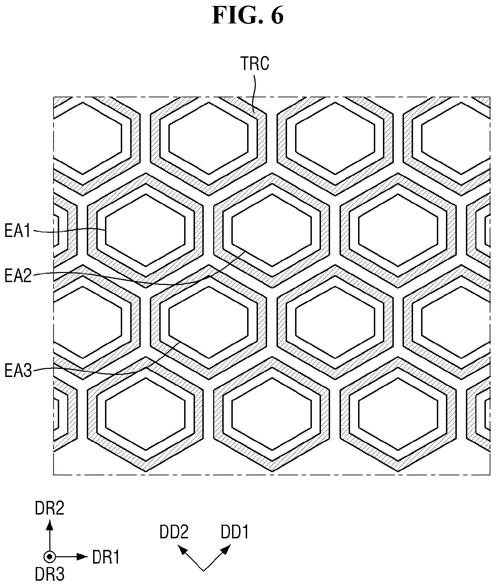

FIG. 6 is a plan view showing first electrodes and emission areas of a plurality of sub-pixels, and a pixel defining film according to another embodiment.

Because the embodiment illustrated in FIG. 6 may be the same or substantially the same as the embodiment described above with reference to FIG. 5, except that the planar shapes of the first emission area EA1, the second emission area EA2, and the third emission area EA3 may be different from those described above with reference to FIG. 5, redundant description thereof may not be repeated.

Referring to FIG. 6, the first emission area EA1, the second emission area EA2, and the third emission area EA3 may be disposed in a hexagonal structure having a hexagonal shape in a plan view. In this case, the first emission area EA1 and the second emission area EA2 may be adjacent to each other in the first direction DR1. The second emission area EA2 and the third emission area EA3 may be adjacent to each other in a first diagonal direction DD1, and the first emission area EA1 and the third emission area EA3 may be adjacent to each other in a second diagonal direction DD2. The first diagonal direction DD1 may be a direction between the first direction DR1 and the second direction DR2, and may refer to a direction inclined by 45 degrees with respect to the first direction DR1 and the second direction DR2. The second diagonal direction DD2 may be a direction perpendicular to or substantially perpendicular to the first diagonal direction DD1.

While FIGS. 5 and 6 show that each of the plurality of pixels PX includes the three emission areas EA1, EA2, and EA3, the present disclosure is not limited thereto. In other words, each of the plurality of pixels PX may include four emission areas.

In addition, the disposition of the emission areas EA1, EA2, and EA3 of the plurality of pixels PX is not limited to those illustrated in FIGS. 5 and 6. For example, the emission areas of the plurality of pixels PX may be disposed in a stripe structure in which the emission areas are arranged along the first direction DR1, an RGBG structure (e.g., a PENTILE^{®} structure, PENTILE^{®} being a duly registered trademark of Samsung Display Co., Ltd.) in which the emission areas are arranged in a diamond shape, or the like.

FIG. 7 is a schematic cross-sectional view taken along the line A-A' of FIG. 5.

Referring to FIG. 7, the display panel 100 may include a semiconductor backplane SBP, a light emitting element backplane EBP, a light emitting element layer EML, the encapsulation layer TFE, an adhesive layer ADL, a color filter layer CFL, a lens array layer LNS, and a cover layer DCL. In some embodiments, the display panel 100 may further include a polarizing plate disposed on the cover layer DCL.

The semiconductor backplane SBP includes the semiconductor substrate SSUB including a plurality of pixel transistors PTR, a plurality of semiconductor insulating films covering the plurality of pixel transistors PTR, and a plurality of contact terminals CTE electrically connected to the plurality of pixel transistors PTR, respectively. The plurality of pixel transistors PTR may be the first to sixth transistors T1 to T6 described above with reference to FIG. 3.

The semiconductor substrate SSUB may be a silicon substrate, a germanium substrate, or a silicon-germanium substrate. The semiconductor substrate SSUB may be a substrate doped with a first type impurity. A plurality of well regions WA may be disposed at (e.g., in or on) the top surface of the semiconductor substrate SSUB. The plurality of well regions WA may be regions doped with a second type impurity. The second type impurity may be different from the first type impurity. For example, when the first type impurity is a p-type impurity, the second type impurity may be an n-type impurity. As another example, when the first type impurity is an n-type impurity, the second type impurity may be a p-type impurity.

Each of the plurality of well regions WA includes a source region SA corresponding to the source electrode of the pixel transistor PTR, a drain region DA corresponding to the drain electrode of the pixel transistor PTR, and a channel region CH disposed between the source region SA and the drain region DA.

A lower insulating film BINS may be disposed between a gate electrode GE and the well region WA. A side insulating film SINS may be disposed on the side surface of the gate electrode GE. The side insulating film SINS may be disposed on the lower insulating film BINS.

Each of the source region SA and the drain region DA may be a region doped with the first type impurity. The gate electrode GE of the pixel transistor PTR may overlap with the well region WA in the third direction DR3. The channel region CH may overlap with the gate electrode GE in the third direction DR3. The source region SA may be disposed on one side of the gate electrode GE, and the drain region DA may be disposed on another side (e.g., an opposite side) of the gate electrode GE.

Each of the plurality of well regions WA further includes a first low-concentration impurity region LDD1 disposed between the channel region CH and the source region SA, and a second low-concentration impurity region LDD2 disposed between the channel region CH and the drain region DA. The first low-concentration impurity region LDD1 may be a region having a lower impurity concentration than that of the source region SA due to the lower insulating film BINS. The second low-concentration impurity region LDD2 may be a region having a lower impurity concentration than that of the drain region DA due to the lower insulating film BINS. The distance between the source region SA and the drain region DA may be increased due to the presence of the first low-concentration impurity region LDD1 and the second low-concentration impurity region LDD2. Therefore, the length of the channel region CH of each of the pixel transistors PTR may be increased, so that a punch-through and a hot carrier phenomena that might be caused by a shorter channel may be prevented or substantially prevented.

A first semiconductor insulating film SINS1 may be disposed on the semiconductor substrate SSUB. The first semiconductor insulating film SINS1 may be formed of a silicon carbonitride (SiCN) or a silicon oxide (SiOx)-based inorganic layer, but the present disclosure is not limited thereto.

A second semiconductor insulating film SINS2 may be disposed on the first semiconductor insulating film SINS1. The second semiconductor insulating film SINS2 may be formed of a silicon oxide (SiOx)-based inorganic layer, but the present disclosure is not limited thereto.

The plurality of contact terminals CTE may be disposed on the second semiconductor insulating film SINS2. Each of the plurality of contact terminals CTE may be connected to any one of the gate electrode GE, the source region SA, and/or the drain region DA of each of the pixel transistors PTR through holes penetrating the first semiconductor insulating film SINS1 and the second semiconductor insulating film SINS2. The plurality of contact terminals CTE may be formed of any one of copper (Cu), aluminium (Al), tungsten (W), molybdenum (Mo), chromium (Cr), gold (Au), titanium (Ti), nickel (Ni), neodymium (Nd), or a suitable alloy including at least one of the aforementioned materials.

A third semiconductor insulating film SINS3 may be disposed on the second semiconductor insulating film SINS2. The third semiconductor insulating film SINS3 may also be disposed on a side surface of each of portions of the plurality of contact terminals CTE disposed on the second semiconductor insulating film SINS2. The top surface of each of the plurality of contact terminals CTE may be exposed without being covered by the third semiconductor insulating film SINS3. The third semiconductor insulating film SINS3 may be formed of a silicon oxide (SiOx)-based inorganic layer, but the present disclosure is not limited thereto.

The semiconductor substrate SSUB may be replaced with a glass substrate, or a polymer resin substrate such as polyimide. In this case, the thin film transistors may be disposed on the glass substrate or the polymer resin substrate. The glass substrate may be a rigid substrate that does not bend, and the polymer resin substrate may be a flexible substrate that can be bent or curved.

The light emitting element backplane EBP includes first to eighth metal layers ML1 to ML8, the reflective electrode layer RL, and a plurality of vias VA1 to VA10. In addition, the light emitting element backplane EBP includes a plurality of interlayer insulating films INS1 to INS11 disposed between the first to eighth metal layers ML1 to ML8.

The first to eighth metal layers ML1 to ML8 may be connected to the plurality of contact terminals CTE exposed from the semiconductor backplane SBP to form a circuit of the sub-pixel SP shown in FIG. 3. The first to sixth transistors T1 to T6 may be formed at (e.g., in or on) the semiconductor backplane SBP, and the connection of the first to sixth transistors T1 to T6 and the first and second capacitors C1 and C2 may be accomplished through the first to eighth metal layers ML1 to ML8. In addition, the connection between the drain region corresponding to the drain electrode of the fourth transistor T4, the source region corresponding to the source electrode of the fifth transistor T5, and the first electrode of the light emitting element LE may also be accomplished through the first to eighth metal layers ML1 to ML8.

The first interlayer insulating film INS1 may be disposed on the semiconductor backplane SBP. Each of the first vias VA1 may penetrate the first interlayer insulating film INS1 to be connected to a corresponding contact terminal CTE exposed from the semiconductor backplane SBP. Each of the first metal layers ML1 may be disposed on the first interlayer insulating film INS1, and may be connected to a corresponding first via VA1.

The second interlayer insulating film INS2 may be disposed on the first interlayer insulating film INS1 and the first metal layers ML1. Each of the second vias VA2 may penetrate the second interlayer insulating film INS2, and be connected to a corresponding exposed first metal layer ML1. Each of the second metal layers ML2 may be disposed on the second interlayer insulating film INS2, and may be connected to a corresponding second via VA2.

The third interlayer insulating film INS3 may be disposed on the second interlayer insulating film INS2 and the second metal layers ML2. Each of the third vias VA3 may penetrate the third interlayer insulating film INS3, and be connected to a corresponding exposed second metal layer ML2. Each of the third metal layers ML3 may be disposed on the third interlayer insulating film INS3, and may be connected to a corresponding third via VA3.

The fourth interlayer insulating film INS4 may be disposed on the third interlayer insulating film INS3 and the third metal layers ML3. Each of the fourth vias VA4 may penetrate the fourth interlayer insulating film INS4, and be connected to a corresponding exposed third metal layer ML3. Each of the fourth metal layers ML4 may be disposed on the fourth interlayer insulating film INS4, and may be connected to a corresponding fourth via VA4.

The fifth interlayer insulating film INS5 may be disposed on the fourth interlayer insulating film INS4 and the fourth metal layers ML4. Each of the fifth vias VA5 may penetrate the fifth interlayer insulating film INS5, and be connected to a corresponding exposed fourth metal layer ML4. Each of the fifth metal layers ML5 may be disposed on the fifth interlayer insulating film INS5, and may be connected to a corresponding fifth via VA5.

The sixth interlayer insulating film INS6 may be disposed on the fifth interlayer insulating film INS5 and the fifth metal layers ML5. Each of the sixth vias VA6 may penetrate the sixth interlayer insulating film INS6, and be connected to a corresponding exposed fifth metal layer ML5. Each of the sixth metal layers ML6 may be disposed on the sixth interlayer insulating film INS6, and may be connected to a corresponding sixth via VA6.

The seventh interlayer insulating film INS7 may be disposed on the sixth interlayer insulating film INS6 and the sixth metal layers ML6. Each of the seventh vias VA7 may penetrate the seventh interlayer insulating film INS7, and be connected to a corresponding exposed sixth metal layer ML6. Each of the seventh metal layers ML7 may be disposed on the seventh interlayer insulating film INS7, and may be connected to a corresponding seventh via VA7.

The eighth interlayer insulating film INS8 may be disposed on the seventh interlayer insulating film INS7 and the seventh metal layers ML7. Each of the eighth vias VA8 may penetrate the eighth interlayer insulating film INS8, and be connected to a corresponding exposed seventh metal layer ML7. Each of the eighth metal layers ML8 may be disposed on the eighth interlayer insulating film INS8, and may be connected to a corresponding eighth via VA8.

The first to eighth metal layers ML1 to ML8 and the first to eighth vias VA1 to VA8 may be formed of the same or substantially the same material as each other. The first to eighth metal layers ML1 to ML8 and the first to eighth vias VA1 to VA8 may be formed of any one of copper (Cu), aluminium (Al), tungsten (W), molybdenum (Mo), chromium (Cr), gold (Au), titanium (Ti), nickel (Ni), neodymium (Nd), or a suitable alloy including at least one of the aforementioned materials. The first to eighth vias VA1 to VA8 may be made of the same or substantially the same material as each other. The first to eighth interlayer insulating films INS1 to INS8 may be formed of a silicon oxide (SiOx)-based inorganic layer, but the present disclosure is not limited thereto.

The thicknesses of the first metal layer ML1, the second metal layer ML2, the third metal layer ML3, the fourth metal layer ML4, the fifth metal layer ML5, and the sixth metal layer ML6 may be larger than the thicknesses of the first via VA1, the second via VA2, the third via VA3, the fourth via VA4, the fifth via VA5, and the sixth via VA6, respectively. The thickness of each of the second metal layer ML2, the third metal layer ML3, the fourth metal layer ML4, the fifth metal layer ML5, and the sixth metal layer ML6 may be larger than the thickness of the first metal layer ML1. The thickness of the second metal layer ML2, the thickness of the third metal layer ML3, the thickness of the fourth metal layer ML4, the thickness of the fifth metal layer ML5, and the thickness of the sixth metal layer ML6 may be the same or substantially the same as each other. For example, the thickness of the first metal layer ML1 may be approximately 1360 Å, the thickness of each of the second metal layer ML2, the third metal layer ML3, the fourth metal layer ML4, the fifth metal layer ML5, and the sixth metal layer ML6 may be approximately 1440 Å, and the thickness of each of the first via VA1, the second via VA2, the third via VA3, the fourth via VA4, the fifth via VA5, and the sixth via VA6 may be approximately 1150 Å.

The thickness of each of the seventh metal layer ML7 and the eighth metal layer ML8 may be larger than the thickness of the first metal layer ML1, the thickness of the second metal layer ML2, the thickness of the third metal layer ML3, the thickness of the fourth metal layer ML4, the thickness of the fifth metal layer ML5, and the thickness of the sixth metal layer ML6. The thickness of the seventh metal layer ML7 and the thickness of the eighth metal layer ML8 may be larger than the thickness of the seventh via VA7 and the thickness of the eighth via VA8. The thickness of each of the seventh via VA7 and the eighth via VA8 may be larger than the thickness of the first via VA1, the thickness of the second via VA2, the thickness of the third via VA3, the thickness of the fourth via VA4, the thickness of the fifth via VA5, and the thickness of the sixth via VA6. The thickness of the seventh metal layer ML7 and the thickness of the eighth metal layer ML8 may be the same or substantially the same as each other. For example, the thickness of each of the seventh metal layer ML7 and the eighth metal layer ML8 may be approximately 9000 Å. The thickness of each of the seventh via VA7 and the eighth via VA8 may be approximately 6000 Å.

The ninth interlayer insulating film INS9 may be disposed on the eighth interlayer insulating film INS8 and the eighth metal layers ML8. The ninth interlayer insulating film INS9 may be formed of a silicon oxide (SiOx)-based inorganic layer, but the present disclosure is not limited thereto.

Each of the ninth vias VA9 may penetrate the ninth interlayer insulating film INS9, and be connected to a corresponding exposed eighth metal layer ML8. The ninth vias VA9 may be formed of any one of copper (Cu), aluminium (Al), tungsten (W), molybdenum (Mo), chromium (Cr), gold (Au), titanium (Ti), nickel (Ni), neodymium (Nd), or a suitable alloy including at least one of the aforementioned materials. The thickness of the ninth via VA9 may be approximately 16500 Å.

The reflective electrode layer RL may be disposed on the ninth interlayer insulating film INS9. The reflective electrode layer RL may include at least one reflective electrode RL1, RL2, RL3, and/or RL4. For example, the reflective electrode RL may include first to fourth reflective electrodes RL1, RL2, RL3, and RL4 as shown in FIG. 7.

Each of the first reflective electrodes RL1 may be disposed on the ninth interlayer insulating film INS9, and may be connected to a corresponding ninth via VA9. The first reflective electrodes RL1 may be formed of any one of copper (Cu), aluminium (Al), tungsten (W), molybdenum (Mo), chromium (Cr), gold (Au), titanium (Ti), nickel (Ni), neodymium (Nd), or a suitable alloy including at least one of the aforementioned materials. For example, the first reflective electrodes RL1 may include titanium nitride (TiN).

Each of second reflective electrodes RL2 may be disposed on a corresponding first reflective electrode RL1. The second reflective electrodes RL2 may be formed of any one of copper (Cu), aluminium (Al), tungsten (W), molybdenum (Mo), chromium (Cr), gold (Au), titanium (Ti), nickel (Ni), neodymium (Nd), or a suitable alloy including at least one of the aforementioned materials. For example, the second reflective electrodes RL2 may include aluminium (Al).

Each of the third reflective electrodes RL3 may be disposed on a corresponding second reflective electrode RL2. The third reflective electrodes RL3 may be formed of any one of copper (Cu), aluminium (Al), tungsten (W), molybdenum (Mo), chromium (Cr), gold (Au), titanium (Ti), nickel (Ni), neodymium (Nd), or a suitable alloy including at least one of the aforementioned materials. For example, the third reflective electrodes RL3 may include titanium nitride (TiN).

The fourth reflective electrodes RL4 may be respectively disposed on the third reflective electrodes RL3. The fourth reflective electrodes RL4 may be formed of any one of copper (Cu), aluminium (Al), tungsten (W), molybdenum (Mo), chromium (Cr), gold (Au), titanium (Ti), nickel (Ni), neodymium (Nd), or a suitable alloy including at least one of the aforementioned materials. For example, the fourth reflective electrodes RL4 may include titanium (Ti).

Because the second reflective electrode RL2 is an electrode that reflects or substantially reflects light from the light emitting elements LE, the thickness of the second reflective electrode RL2 may be greater than the thickness of each of the first reflective electrode RL1, the third reflective electrode RL3, and the fourth reflective electrode RL4. For example, the thickness of each of the first reflective electrode RL1, the third reflective electrode RL3, and the fourth reflective electrode RL4 may be approximately 100 Å, and the thickness of the second reflective electrode RL2 may be 850 Å.

The tenth interlayer insulating film INS10 may be disposed on the ninth interlayer insulating film INS9. The tenth interlayer insulating film INS10 may be disposed between the reflective electrode layers RL that are adjacent to each other. The tenth interlayer insulating film INS10 may be disposed on the reflective electrode layer RL in the third sub-pixel SP3. The tenth interlayer insulating film INS10 may be formed of a silicon oxide (SiOx)-based inorganic layer, but the present disclosure is not limited thereto.

The eleventh interlayer insulating film INS11 may be disposed on the tenth interlayer insulating film INS10 and the reflective electrode layer RL. The eleventh interlayer insulating film INS11 may be formed of a silicon oxide (SiOx)-based inorganic layer, but the present disclosure is not limited thereto.

In at least one of the first sub-pixel SP1, the second sub-pixel SP2, or the third sub-pixel SP3, the tenth interlayer insulating film INS10 and the eleventh interlayer insulating film INS11 may not be disposed under the first electrode AND in consideration of a resonance distance of the light emitted from the light emitting elements LE.

For example, the first electrode AND of the first sub-pixel SP1 may be directly disposed on the fourth reflective electrode RL4, and the first electrode AND of the first sub-pixel SP1 may not overlap with the tenth interlayer insulating film INS10 and the eleventh interlayer insulating film INS11. The first electrode AND of the second sub-pixel SP2 may be disposed on the eleventh interlayer insulating film INS11, and the eleventh interlayer insulating film INS11 may be directly disposed on the fourth reflective electrode RL4. In other words, the first electrode AND of the second sub-pixel SP2 may not overlap with the tenth interlayer insulating film INS10. The first electrode AND of the third sub-pixel SP3 may be disposed on the eleventh interlayer insulating film INS11, and may overlap with the tenth interlayer insulating film INS10.

In an embodiment, a distance between the first electrode AND and the reflective electrode layer RL may be different in the first sub-pixel SP1, the second sub-pixel SP2, and the third sub-pixel SP3. In order to adjust the distance from the reflective electrode layer RL to a second electrode CAT according to the main wavelength of the light emitted from each of the first sub-pixel SP1, the second sub-pixel SP2, and the third sub-pixel SP3, the presence or absence of the tenth interlayer insulating film INS10 and the eleventh interlayer insulating film INS11 may be set in each of the first sub-pixel SP1, the second sub-pixel SP2, and the third sub-pixel SP3. For example, in FIG. 7, the distance between the first electrode AND and the reflective electrode layer RL in the third sub-pixel SP3 may be larger than the distance between the first electrode AND and the reflective electrode layer RL in the second sub-pixel SP2 and the distance between the first electrode AND and the reflective electrode layer RL in the first sub-pixel SP1. The distance between the first electrode AND and the reflective electrode layer RL in the second sub-pixel SP2 may be larger than the distance between the first electrode AND and the reflective electrode layer RL in the first sub-pixel SP1. However, the present disclosure is not limited thereto. The distance between the first electrode AND and the reflective electrode layer RL in each of the sub-pixels SP1, SP2, and SP3 may be variously modified and designed as needed or desired.

In addition, although the tenth interlayer insulating film INS10 and the eleventh interlayer insulating film INS11 are illustrated in FIG. 7, a twelfth interlayer insulating film may be further arranged under the first electrode AND of the sub-pixel SP. In this case, the eleventh interlayer insulating film INS11 and the twelfth interlayer insulating film may be disposed under the first electrode AND of the second sub-pixel SP2, and the tenth interlayer insulating film INS10, the eleventh interlayer insulating film INS11, and the twelfth interlayer insulating film may be disposed under the first electrode AND of the third sub-pixel SP3. As another example, the eleventh interlayer insulating film INS11 may be omitted as needed or desired.

Each of the tenth vias VA10 may penetrate the tenth interlayer insulating film INS10 and/or the eleventh interlayer insulating film INS11 in the second sub-pixel SP2 and the third sub-pixel SP3, and may be connected to a corresponding exposed fourth reflective electrode RL4. The tenth vias VA10 may be formed of any one of copper (Cu), aluminium (Al), tungsten (W), molybdenum (Mo), chromium (Cr), gold (Au), titanium (Ti), nickel (Ni), neodymium (Nd), or a suitable alloy including at least one of the aforementioned materials. The thickness of the tenth via VA10 in the second sub-pixel SP2 may be smaller than the thickness of the tenth via VA10 in the third sub-pixel SP3.

The light emitting element layer EML may be disposed on the light emitting element backplane EBP. The light emitting element layer EML may include the light emitting elements LE, each having the first electrode AND, the light emitting stack IL (e.g., an intermediate layer IL), and the second electrode CAT, the pixel defining film PDL, and the plurality of trenches TRC.

The first electrode AND of each of the light emitting elements LE may be disposed on the tenth interlayer insulating film INS10 or the eleventh interlayer insulating film INS11, and may be connected to a corresponding tenth via VA10. The first electrode AND of each of the light emitting elements LE may be connected to a corresponding drain region DA or a corresponding source region SA of a corresponding pixel transistor PTR through the tenth via VA10, the first to fourth reflective electrodes RL1 to RL4, the first to ninth vias VA1 to VA9, the first to eighth metal layers ML1 to ML8, and the contact terminal CTE. The first electrode AND of each of the light emitting elements LE may be formed of any one of copper (Cu), aluminium (Al), tungsten (W), molybdenum (Mo), chromium (Cr), gold (Au), titanium (Ti), nickel (Ni), neodymium (Nd), or a suitable alloy including at least one of the aforementioned materials. For example, the first electrode AND of each of the light emitting elements LE may include (e.g., may be) titanium nitride (TiN).

The pixel defining film PDL may be disposed on a portion of the first electrode AND of each of the light emitting elements LE. The pixel defining film PDL may cover an edge of the first electrode AND of each of the light emitting elements LE. The pixel defining film PDL may serve to partition the first emission areas EA1, the second emission areas EA2, and the third emission areas EA3 from each other.

The first emission area EA1 may be defined as an area in which the first electrode AND, the light emitting stack IL, and the second electrode CAT are sequentially stacked in the first sub-pixel SP1 to emit light. The second emission area EA2 may be defined as an area in which the first electrode AND, the light emitting stack IL, and the second electrode CAT are sequentially stacked in the second sub-pixel SP2 to emit light. The third emission area EA3 may be defined as an area in which the first electrode AND, the light emitting stack IL, and the second electrode CAT are sequentially stacked in the third sub-pixel SP3 to emit light.

The pixel defining film PDL may include first to third pixel defining films PDL1, PDL2, and PDL3. The first pixel defining film PDL1 may be disposed on the edge of the first electrode AND of each of the light emitting elements LE. The second pixel defining film PDL2 may be disposed on the first pixel defining film PDL1. The third pixel defining film PDL3 may be disposed on the second pixel defining film PDL2. The first pixel defining film PDL1, the second pixel defining film PDL2, and the third pixel defining film PDL3 may be formed of a silicon oxide (SiOₓ)-based inorganic layer, but the present disclosure is not limited thereto. The first pixel defining film PDL1, the second pixel defining film PDL2, and the third pixel defining film PDL3 may each have a thickness of about 500 Å.

When the first pixel defining film PDL1, the second pixel defining film PDL2, and the third pixel defining film PDL3 are formed as one pixel defining film, the height of the one pixel defining film may be increased, so that a first inorganic encapsulation layer TFE1 may be cut off due to a step coverage. The step coverage refers to a ratio of the degree of the thin film coated on an inclined portion to the degree of the thin film coated on a flat portion. The lower the step coverage, the more likely it is that the thin film will be cut off at inclined portions.

In order to prevent or substantially prevent the first inorganic encapsulation layer TFE1 from being cut off due to the step coverage, the first pixel defining film PDL1, the second pixel defining film PDL2, and the third pixel defining film PDL3 may have a cross-sectional structure having a stepped portion. For example, the width of the first pixel defining film PDL1 may be greater than the width of the second pixel defining film PDL2 and the width of the third pixel defining film PDL3. The width of the second pixel defining film PDL2 may be greater than the width of the third pixel defining film PDL3. The width of the first pixel defining film PDL1 refers to a horizontal length of the first pixel defining film PDL1 defined in the first direction DR1 and the second direction DR2.

Each of the plurality of trenches TRC may penetrate the first pixel defining film PDL1, the second pixel defining film PDL2, and the third pixel defining film PDL3. In each of the plurality of trenches TRC, a portion of the tenth interlayer insulating film INS10 may be dug, and the eleventh interlayer insulating film INS11 may have a shape through which the eleventh interlayer insulating film INS11 is penetrated.

At least one trench TRC may be disposed between adjacent sub-pixels SP1, SP2, and SP3. FIG. 7 illustrates that two trenches TRC are disposed between the adjacent sub-pixels SP1, SP2, and SP3, but the present disclosure is not limited thereto.

The light emitting stack IL may include a plurality of intermediate layers. FIG. 7 illustrates that the light emitting stack IL has a three-tandem structure including a first intermediate layer IL1, a second intermediate layer IL2, and a third intermediate layer IL3, but the present disclosure is not limited thereto. For example, the light emitting stack IL may have a two-tandem structure including two intermediate layers.

In the three-tandem structure, the light emitting stack IL may have a tandem structure including a plurality of intermediate layers IL1, IL2, and IL3 that emit different colored light from each other. For example, the light emitting stack IL may include the first intermediate layer IL1 that emits light of the first color, the second intermediate layer IL2 that emits light of the third color, and the third intermediate layer IL3 that emits light of the second color. The first intermediate layer IL1, the second intermediate layer IL2, and the third intermediate layer IL3 may be sequentially stacked.

The first intermediate layer IL1 may have a structure in which a first hole transport layer, a first organic light emitting layer that emits light of the first color, and a first electron transport layer are sequentially stacked. The second intermediate layer IL2 may have a structure in which a second hole transport layer, a second organic light emitting layer that emits light of the third color, and a second electron transport layer are sequentially stacked. The third intermediate layer IL3 may have a structure in which a third hole transport layer, a third organic light emitting layer that emits light of the second color, and a third electron transport layer are sequentially stacked.

A first charge generation layer for supplying charges to the second intermediate layer IL2 and for supplying electrons to the first intermediate layer IL1 may be disposed between the first intermediate layer IL1 and the second intermediate layer IL2. The first charge generation layer may include an N-type charge generation layer that supplies electrons to the first intermediate layer IL1, and a P-type charge generation layer that supplies holes to the second intermediate layer IL2. The N-type charge generation layer may include a dopant of a metal material.

A second charge generation layer for supplying charges to the third intermediate layer IL3 and for supplying electrons to the second intermediate layer IL2 may be disposed between the second intermediate layer IL2 and the third intermediate layer IL3. The second charge generation layer may include an N-type charge generation layer that supplies electrons to the second intermediate layer IL2, and a P-type charge generation layer that supplies holes to the third intermediate layer IL3.

The first intermediate layer IL1 may be disposed on the first electrodes AND and the pixel defining film PDL, and may be disposed on the bottom surface of each trench TRC. Due to the trench TRC, the first intermediate layer IL1 may be cut off between adjacent sub-pixels SP1, SP2, and SP3. The second intermediate layer IL2 may be disposed on the first intermediate layer IL1. Due to the trench TRC, the second intermediate layer IL2 may be cut off between adjacent sub-pixels SP1, SP2, and SP3. A void or an empty space may be disposed between the first intermediate layer IL1 and the second intermediate layer IL2. The third intermediate layer IL3 may be disposed on the second intermediate layer IL2. The third intermediate layer IL3 may be disposed to cover the second intermediate layer IL2 in each of the trenches TRC without being cut off by the trench TRC. In other words, in the three-tandem structure, each of the trenches TRC may be a structure for cutting off the first charge generation layer, the second charge generation layer, and the first and second intermediate layers IL1 and IL2 of the light emitting element layer EML between the adjacent sub-pixels SP1, SP2, and SP3. In addition, in the two-tandem structure, each of the trenches TRC may be a structure for cutting off the charge generation layer disposed between a lower intermediate layer and an upper intermediate layer, and the lower intermediate layer.

In order to stably cut off the first and second intermediate layers IL1 and IL2 of the light emitting element layer EML between the adjacent sub-pixels SP1, SP2, and SP3, the height of each trench TRC may be larger than the height of the pixel defining film PDL. The height of each of the plurality of trenches TRC refers to a length of each of the plurality of trenches TRC in the third direction DR3. The height of the pixel defining film PDL refers to a length of the pixel defining film PDL in the third direction DR3. In order to cut off the first to third intermediate layers IL1, IL2, and IL3 of the light emitting element layer EML between the neighboring sub-pixels SP1, SP2, and SP3, another structure may exist instead of the trench TRC. For example, instead of the trench TRC, a reverse tapered partition wall may be disposed on the pixel defining film PDL.

The number of the intermediate layers IL1, IL2, and IL3 that emit different colored light from each other is not limited to that shown in FIG. 7. For example, the light emitting stack IL may include two intermediate layers. In this case, one of the two intermediate layers may be the same or substantially the same as the first intermediate layer IL1, and the other may include a second hole transport layer, a second organic light emitting layer, a third organic light emitting layer, and a second electron transport layer. In this case, a charge generation layer for supplying electrons to one intermediate layer and for supplying charges to the other intermediate layer may be disposed between the two intermediate layers.

In addition, FIG. 7 illustrates that the first to third intermediate layers IL1, IL2, and IL3 are all disposed in the first emission area EA1, the second emission area EA2, and the third emission area EA3, but the present disclosure is not limited thereto. For example, the first intermediate layer IL1 may be disposed in the first emission area EA1, but may not be disposed in the second emission area EA2 and the third emission area EA3. Furthermore, the second intermediate layer IL2 may be disposed in the second emission area EA2, but may not be disposed in the first emission area EA1 and the third emission area EA3. Further, the third intermediate layer IL3 may be disposed in the third emission area EA3, but may not be disposed in the first emission area EA1 and the second emission area EA2. In this case, the first to third color filters CF1, CF2, and CF3 of an optical layer may be omitted.

The second electrode CAT may be disposed on the third intermediate layer IL3. The second electrode CAT may be disposed on the third intermediate layer IL3 in each of the plurality of trenches TRC. The second electrode CAT may be formed of a transparent conductive material (TCO), such as ITO or IZO, that may transmit light, or a semi-transmissive conductive material, such as magnesium (Mg), silver (Ag), or an alloy of Mg and Ag. When the second electrode CAT is formed of a semi-transmissive conductive material, the light emission efficiency may be improved in each of the first to third sub-pixels SP1, SP2, and SP3 due to a micro-cavity effect.

The encapsulation layer TFE may be disposed on the light emitting element layer EML. The encapsulation layer TFE may include at least one inorganic encapsulation layer TFE1 and TFE3 to prevent or substantially prevent oxygen or moisture from permeating into the light emitting element layer EML. In addition, the encapsulation layer TFE may include at least one organic layer to protect the light emitting element layer EML from foreign substances, such as dust. For example, the encapsulation layer TFE may include the first inorganic encapsulation layer TFE1, the organic encapsulation layer TFE2, and a second inorganic encapsulation layer TFE3.

The first inorganic encapsulation layer TFE1 may be disposed on the second electrode CAT. The organic encapsulation layer TFE2 may be disposed on the first inorganic encapsulation layer TFE1, and the second inorganic encapsulation layer TFE3 may be disposed on the organic encapsulation layer TFE2. The first inorganic encapsulation layer TFE1 and the second inorganic encapsulation layer TFE3 may be formed of multiple layers in which one or more inorganic layers of silicon nitride (SiNₓ), silicon oxynitride (SiOₓN_{y}), silicon oxide (SiOₓ), titanium oxide (TiOₓ), and aluminium oxide (AlOₓ) are alternately stacked. The organic encapsulation layer TFE2 may be a monomer. As another example, the organic encapsulation layer TFE2 may be an organic layer, such as an acryl resin, an epoxy resin, a phenolic resin, a polyamide resin, a polyimide resin, or the like.

The adhesive layer ADL may be disposed on the encapsulation layer TFE. The adhesive layer ADL may be a layer for bonding the encapsulation layer TFE to a layer disposed thereon. The adhesive layer ADL may be a double-sided adhesive member. In addition, the adhesive layer ADL may be a transparent adhesive member, such as a transparent adhesive or a transparent adhesive resin.

The color filter layer CFL, the lens array layer LNS, and the cover layer DCL may be disposed on the adhesive layer ADL. The color filter layer CFL, the lens array layer LNS, and the cover layer DCL may constitute the optical layer of the display panel 100.

The color filter layer CFL may include the plurality of color filters CF1, CF2, and CF3, and may be disposed on the adhesive layer ADL. The first color filter CF1 may overlap with the first emission area EA1 of the first sub-pixel SP1. The first color filter CF1 may transmit light of the first color (e.g., light of a red wavelength band). The first color filter CF1 may transmit light of the first color from among light emitted from the first emission area EA1.

The second color filter CF2 may overlap with the second emission area EA2 of the second sub-pixel SP2. The second color filter CF2 may transmit light of the second color (e.g., light of a green wavelength band). Thus, the second color filter CF2 may transmit light of the second color from among light emitted from the second emission area EA2.

The third color filter CF3 may overlap with the third emission area EA3 of the third sub-pixel SP3. The third color filter CF3 may transmit light of the third color (e.g., light of a blue wavelength band). Thus, the third color filter CF3 may transmit light of the third color from among light emitted from the third emission area EA3.

The lens array layer LNS may be disposed on the color filter layer CFL in the display area DAA. The lens array layer LNS may include a plurality of lenses disposed in the display area DAA. The plurality of lenses may be disposed on the first color filter CF1, the second color filter CF2, and the third color filter CF3, respectively. Each of the plurality of lenses may be a structure for increasing a ratio of light directed to the front of the display device 10. Each of the plurality of lenses may have a cross-sectional shape that is convex in an upward direction.

The cover layer DCL may be disposed on the lens array layer LNS. The cover layer DCL may be directly disposed on the plurality of lenses of the lens array layer LNS. The cover layer DCL may have a desired refractive index (e.g., a predetermined refractive index) so that light travels in the third direction DR3 at an interface between the plurality of lenses and the cover layer DCL. Additionally, the cover layer DCL may be a planarization layer. The cover layer DCL may be an organic layer, such as an acryl resin, an epoxy resin, a phenolic resin, a polyamide resin, a polyimide resin or the like.

In some embodiments, a polarizing plate may be further disposed on the cover layer DCL. The polarizing plate may be a structure for preventing or substantially preventing visibility degradation that may be caused by a reflection of external light. The polarizing plate may include a linear polarizing plate and a phase retardation film. For example, the phase retardation film may be a λ/4 plate (quarter-wave plate), but the present disclosure is not limited thereto. However, when visibility degradation caused by a reflection of external light is sufficiently overcome by the first to third color filters CF1, CF2, and CF3, the polarizing plate may be omitted.

As illustrated in FIG. 7, by forming the light emitting element backplane EBP and the light emitting element layer EML on the semiconductor substrate SSUB at (e.g., in or on) which a plurality of transistors are formed, the size of the plurality of pixels PX may be reduced (e.g., may be greatly reduced), so that the display device 10 that displays high-resolution images may be provided.

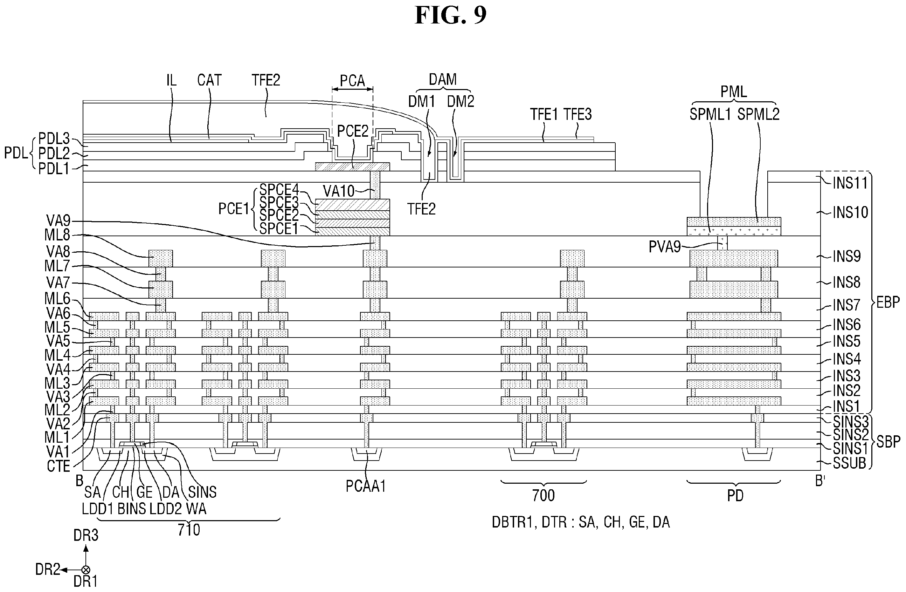

FIG. 8 is an enlarged view showing the area X of FIG. 4. FIG. 9 is a schematic cross-sectional view taken along the line B-B' of FIG. 8.

The area X of FIG. 4 may be an area disposed on the lower side, which is one side of the display area DAA in the second direction DR2. FIGS. 8 and 9 show the first distribution circuit 710, the power connection portion PCA, the dam structure DAM, the data driver 700, and the pad PD disposed on the lower side of the display area DAA.

Referring to FIGS. 8 and 9, the first distribution circuit 710, the power connection portion PCA, the dam structure DAM, the data driver 700, and the pad PD may be sequentially disposed along the second direction DR2 on the lower side of the display area DAA. However, the present disclosure is not limited thereto. In some embodiments, the power connection portion PCA may overlap with the first distribution circuit 710 or the data driver 700 in the thickness direction, and the dam structure DAM may overlap with the first distribution circuit 710 or the data driver 700 in the thickness direction.

The first distribution circuit 710 may include a plurality of first distribution transistors DBTR1. Because each of the plurality of first distribution transistors DBTR1 may be formed in the same or substantially the same way as that of the pixel transistors PTR described above with reference to FIG. 7, redundant description thereof may not be repeated. In addition, because the first to eighth metal layers ML1 to ML8 and the first to eighth vias VA1 to VA8 that are electrically connected to the plurality of first distribution transistors DBTR1 are also the same or substantially the same as those described above with reference to FIG. 8, redundant description thereof may not be repeated.

The power connection portion PCA includes a first power connection area PCAA1 of the semiconductor substrate SSUB, a first power connection electrode PCE1, and a second power connection electrode PCE2.

The first driving voltage VSS may be applied to the first power connection area PCAA1 of the semiconductor substrate SSUB.

The first power connection electrode PCE1 may be disposed on the ninth insulating film INS9. The first power connection electrode PCE1 may be connected to the first power connection area PCAA of the semiconductor substrate SSUB through the first to eighth metal layers ML1 to ML8 and the first to eighth vias VA1 to VA8.

The first power connection electrode PCE1 may include first to fourth sub-power connection electrodes SPCE1 to SPCE4. The first to fourth sub-power connection electrodes SPCE1 to SPCE4 of the first power connection electrode PCE1 may be the same or substantially the same as the first to fourth reflective electrode layers RL1 to RL4 of the reflective electrode layer RL. In other words, the first sub-power connection electrode layer SPCE1 may correspond to the first reflective electrode layer RL1, the second sub-power connection electrode layer SPCE2 may correspond to the second reflective electrode layer RL2, the third sub-power connection electrode layer SPCE3 may correspond to the third reflective electrode layer RL3, and the fourth sub-power connection electrode layer SPCE4 may correspond to the fourth reflective electrode layer RL4.

The second power connection electrode PCE2 may be disposed on the tenth interlayer insulating film INS10 or the eleventh interlayer insulating film INS11. The second power connection electrode PCE2 may be connected to the first power connection electrode PCE1 through the tenth via VA10. The second power connection electrode PCE2 may include the same or substantially the same material as that of the first electrode AND of the light emitting element LE. The second power connection electrode PCE2 may be partitioned by the pixel defining film PDL. The second electrode CAT of the light emitting element LE may be connected to the second power connection electrode PCE2 that is exposed and not covered by the pixel defining film PDL.

The dam structure DAM may include the first dam DM1 and the second dam DM2. The first dam DM1 and the second dam DM2 may be the same or substantially the same as the trench TRC. Each of the first dam DM1 and the second dam DM2 may have a trench shape that penetrates at least the first pixel defining film PDL1, the second pixel defining film PDL2, and the third pixel defining film PDL3. Each of the first dam DM1 and the second dam DM2 may penetrate the pixel defining film PDL and the eleventh interlayer insulating film INS11.

In the first dam DM1, the first inorganic encapsulation layer TFE1 may be disposed on the bottom surface thereof, the organic encapsulation layer TFE2 may be disposed on the first inorganic encapsulation layer TFE1, and the second inorganic encapsulation layer TFE3 may be disposed on the organic encapsulation layer TFE2. The organic encapsulation layer TFE2 may be disposed to fill a portion of the first dam DM1. In the second dam DM2, the first inorganic encapsulation layer TFE1 may be disposed on the bottom surface thereof, and the second inorganic encapsulation layer TFE3 may be disposed on the first inorganic encapsulation layer TFE1. The organic encapsulation layer TFE2 may not be disposed in the second dam DM2. In the display device 10, the dam structure DAM is composed of two or more dams DM1 and DM2, and the organic encapsulation layer TFE2 may be disposed in the innermost dam, for example, in the first dam DM1, and may cover the innermost dam. However, the organic encapsulation layer TFE2 may not be disposed in the outermost dam, for example, such as the second dam DM2, and may not cover the outermost dam. Due to the presence of the first dam DM1 and the second dam DM2, the organic encapsulation layer TFE2 may be prevented or substantially prevented from flowing to the pad portion PDA to cover the pads PD. The organic encapsulation layer TFE2 may be prevented from covering the pads PD, and thus, allowing the pads PD to be electrically connected to the circuit board 300.

According to an embodiment, in the display device 10, the multiple dams DM1 and DM2 may include dam patterns DMP1 and DMP2 that are spaced apart from each other. The first dam DM1 may include a plurality of first dam patterns DMP1 that are spaced apart from each other, and the second dam DM2 may include a plurality of second dam patterns DMP2 that are spaced apart from each other. The first dam patterns DMP1 may be disposed to be spaced apart from each other while surrounding (e.g., around a periphery of) the display area DAA, and the second dam patterns DMP2 may be disposed to be spaced apart from each other while surrounding (e.g., around a periphery of) the first dam DM1. For example, the plurality of first dam patterns DMP1 may be disposed along an edge of the display area DAA, and may be disposed to be spaced apart from each other in the first direction DR1 on the lower side of the display area DAA, as illustrated in FIG. 8. The first dam patterns DMP1 may be disposed to be spaced apart from each other in the first direction DR1 on the upper side of the display area DAA as well, and the first dam patterns DMP1 may be disposed to be spaced apart from each other in the second direction DR2 on the left and right sides of the display area DAA. The second dam patterns DMP2 may be disposed outside the first dam patterns DMP1, and may be disposed side by side with the first dam patterns DMP1. For example, the second dam patterns DMP2 may be disposed to be spaced apart from each other in the first direction DR1 on the upper and lower sides of the display area DAA, and may be disposed to be spaced apart from each other in the second direction DR2 on the left and right sides of the display area DAA. In the display device 10, the dams DM1 and DM2 of the dam structure DAM may include the dam patterns DMP1 and DMP2 that are spaced apart from each other, so that the organic material of the organic encapsulation layer TFE2 may be uniformly or substantially uniformly spread.

The data driver 700 may include a plurality of data transistors DTR. Because each of the plurality of data transistors DTR may be formed the same or substantially the same as the pixel transistors PTR described above with reference to FIG. 7, redundant description may not be repeated. In addition, because the first to eighth metal layers ML1 to ML8 and the first to eighth vias VA1 to VA8 that are electrically connected to the plurality of data transistors DTR may be the same or substantially the same as those described above with reference to FIG. 7, redundant description thereof may not be repeated.

Each of the pads PD may include a pad metal layer PML. The pad metal layer PML may include a first sub-pad metal layer SPML1 and a second sub-pad metal layer SPML2. The first sub-pad metal layer SPML1 may be formed of any one of copper (Cu), aluminium (Al), tungsten (W), molybdenum (Mo), chromium (Cr), gold (Au), titanium (Ti), nickel (Ni), neodymium (Nd), or a suitable alloy including at least one of the aforementioned materials. The second sub-pad metal layer SPML2 may be formed of any one of copper (Cu), aluminium (Al), tungsten (W), molybdenum (Mo), chromium (Cr), gold (Au), titanium (Ti), nickel (Ni), neodymium (Nd), or a suitable alloy including at least one of the aforementioned materials. For example, the first sub-pad metal layer SPML1 may be made of aluminium (Al), and may have a thickness of approximately 12,000 Å. In addition, the second sub-pad metal layer SPML2 may be made of titanium nitride (TiN), and may have a thickness of approximately 600 Å. The thickness of the pad metal layer PML may be greater than the thickness of the reflective electrode layer RL.

A portion of the top surface of the pad metal layer PML of each pad PD may be exposed without being covered by the tenth interlayer insulating film INS10. The first sub-pad metal layer SPML1 may be connected to a pad via PVA9 that penetrates the ninth insulating film INS9 to be connected to the eighth metal layer ML8.

The encapsulation layer TFE may also be disposed in a portion of the non-display area NDA located on the lower side of the display area DAA. While the organic encapsulation layer TFE2 of the encapsulation layer TFE is disposed up to the first dam DM1, the inorganic encapsulation layers TFE1 and TFE3 of the encapsulation layer TFE may be disposed up to the outside of the dam structure DAM to form an inorganic junction area.

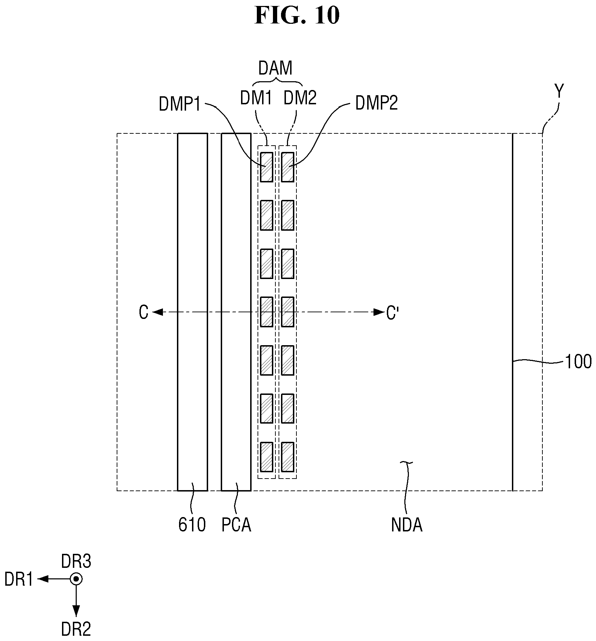

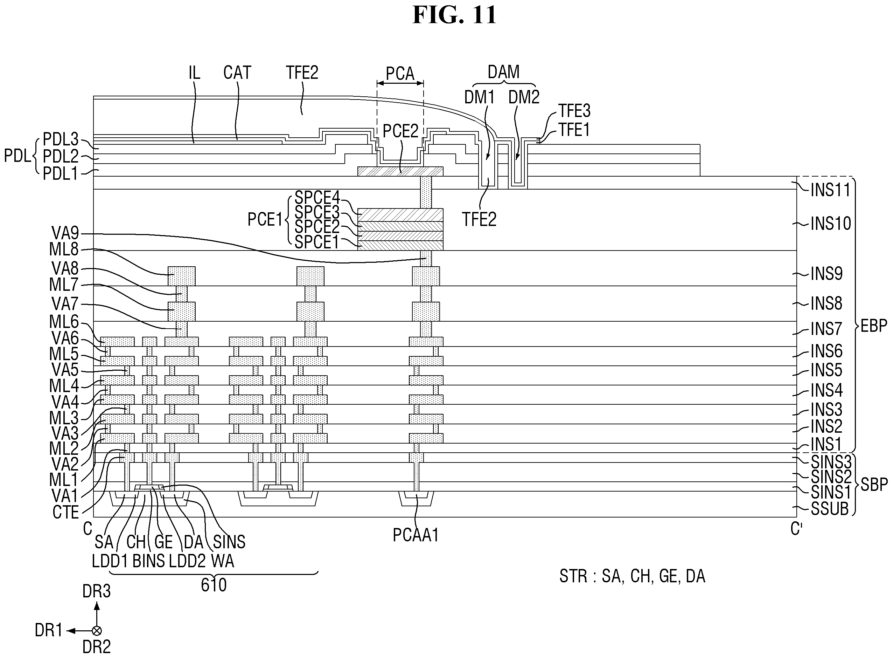

FIG. 10 is an enlarged view showing the area Y of FIG. 4. FIG. 11 is a schematic cross-sectional view taken along the line C-C' of FIG. 10.

The area Y of FIG. 4 may be an area disposed on the left side, which is one side of the display area DAA in the first direction DR1. FIGS. 10 and 11 illustrate the scan driver 610, the power connection portion PCA, and the dam structure DAM disposed on the left side of the display area DAA.

Referring to FIGS. 10 and 11, the scan driver 610, the power connection portion PCA, and the dam structure DAM may be sequentially disposed along the first direction DR1 on the left side of the display area DAA. However, the present disclosure is not limited thereto, and the power connection portion PCA may overlap with the scan driver 610 in the thickness direction, and the dam structure DAM may overlap with the scan driver 610 in the thickness direction.

The scan driver 610 may include a plurality of scan transistors STR. Because each of the plurality of scan transistors STR may be formed the same or substantially the same as the pixel transistors PTR described above with reference to FIG. 7, redundant description thereof may not be repeated. In addition, because the first to eighth metal layers ML1 to ML8 and the first to eighth vias VA1 to VA8 electrically connected to the plurality of scan transistors STR may be the same or substantially the same as those described above with reference to FIG. 8, redundant description thereof may not be repeated.

Because the power connection portion PCA and the dam structure DAM are the same or substantially the same as those described above with reference to FIGS. 8 and 9, redundant description thereof may not be repeated.

In addition, because the area disposed on the second side of the display area DAA is the same or substantially the same as those described above with reference to FIGS. 10 and 11, except that the scan driver 610 replaces the emission driver 620, redundant description thereof may not be repeated.

The encapsulation layer TFE may also be disposed in a portion of the non-display area NDA located on the left side of the display area DAA. While the organic encapsulation layer TFE2 of the encapsulation layer TFE is disposed up to the first dam DM1, the inorganic encapsulation layers TFE1 and TFE3 of the encapsulation layer TFE may be disposed up to the outside of the dam structure DAM to form an inorganic junction area.

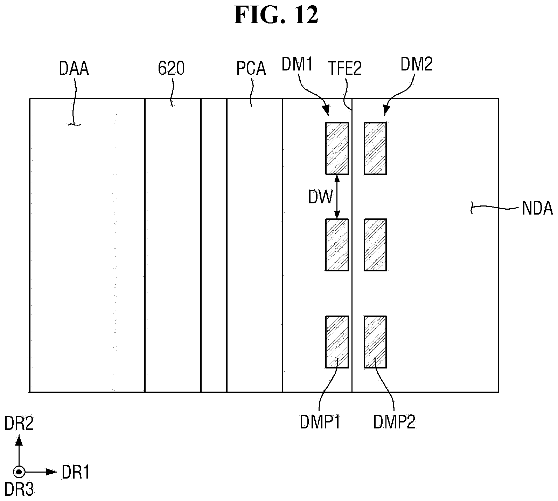

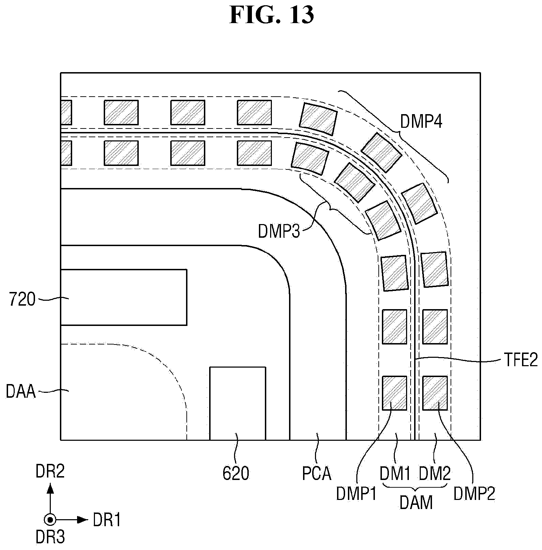

FIGS. 12 and 13 are plan views illustrating a schematic disposition of an encapsulation layer and dam structures of a display device according to an embodiment. FIG. 12 illustrates the disposition of the first dam DM1 and the second dam DM2 disposed on the right side of the display area DAA in the first direction DR1. FIG. 13 illustrates the disposition of the first dam DM1 and the second dam DM2 disposed at a diagonal edge of the display area DAA.

Referring to FIGS. 12 and 13, in the display device 10 according to an embodiment, the multiple dams DM1 and DM2 may include the dam patterns DMP1 and DMP2 that are spaced apart from each other. The first dam patterns DMP1 of the first dam DM1 may be disposed to be spaced apart from each other along an edge of the display area DAA. The length of each of the first dam patterns DMP1 measured in a direction in which they are spaced apart from each other may be larger than the width thereof measured in a direction perpendicular to or substantially perpendicular to the direction in which the first dam patterns DMP1 are spaced apart from each other. For example, the first dam patterns DMP1 may be spaced apart from each other in the second direction DR2 on the left and right sides of the display area DAA, and the length of each of the first dam patterns DMP1 measured in the second direction DR2 may be larger than the width thereof measured in the first direction DR1. The first dam patterns DMP1 may be spaced apart from each other in the first direction DR1 on the upper and lower sides of the display area DAA, and the length of each of the first dam patterns DMP1 measured in the first direction DR1 may be larger than the width thereof measured in the second direction DR2.

The second dam patterns DMP2 of the second dam DM2 may be disposed outside the first dam DM1 to be spaced apart from each other along the first dam patterns DMP1. The second dam patterns DMP2 may have the same or substantially the same shape as that of the first dam patterns DMP1, and may be disposed to be spaced apart from each other side by side with the first dam patterns DMP1. For example, one first dam pattern DMP1 and one second dam pattern DMP2 may be disposed side by side with each other in a pair, and may be disposed along the edge of the display area DAA.

The figures show that the display device 10 includes one first dam DM1 and one second dam DM2, and the two dams DM1 and DM2 form the dam structure DAM. However, the present disclosure is not limited thereto, and the display device 10 may include a larger number of dams. In this case, the first dam DM1, which is disposed on the inner side to be closest to the display area DAA among the multiple dams DM1 and DM2, may be the innermost dam, and the second dam DM2 disposed on the outer side to be adjacent to the edge of the display device 10 may be the outermost dam.

The display device 10 may include the encapsulation layer TFE disposed in the display area DAA and a partial region of the non-display area NDA. Each of the first inorganic encapsulation layer TFE1 and the second inorganic encapsulation layer TFE3 of the encapsulation layer TFE may be disposed up to the outside of the dam structure DAM to form an inorganic junction area. The organic encapsulation layer TFE2 may cover at least one of the multiple dams DM1 and DM2 of the dam structure DAM, for example, such as the first dam DM1, which is the innermost dam, but may not cover at least one dam, for example, such as the second dam DM2, which is the outermost dam. The dam structure DAM may include the multiple dams DM1 and DM2 to prevent or substantially prevent the organic encapsulation layer TFE2 including the organic material from overflowing beyond the dam structure DAM up to the outer portion of the display device 10.

In an embodiment, the organic encapsulation layer TFE2 may be formed through an inkjet printing process in which one or more organic insulating materials are discharged onto the display area DAA. When ink droplets containing the organic insulating material are discharged into the area surrounded (e.g., around a periphery thereof) by the dam structure DAM while being spaced (e.g., distanced) apart from each other, the organic insulating material may be spread from the area where the ink drops are discharged to the surrounding area, so that the organic insulating material may be coated on the entire area surrounded (e.g., around a periphery thereof) by the dam structure DAM.

In the display device 10, the dam structures DAM for preventing or substantially preventing the overflow of the organic materials include the dam patterns DMP1 and DMP2 that are spaced apart from each other, so when the ink droplets are spread, they may be guided to be spread evenly at the edge thereof. As compared to a case when the dams DM1 and DM2 of the dam structure DAM have a linear shape, when the dams DM1 and DM2 have a shape in which the dam patterns DMP1 and DMP2 are spaced apart from each other, the organic materials of the ink drops may sequentially flow toward the dam patterns DMP1 and DMP2 or regions between them, and straightness may be improved at the edge of the organic encapsulation layer TFE2. The thickness of the organic encapsulation layer TFE2 may be reduced by reducing the spacing of the ink drops. Even if the spacing of the ink drops is reduced, straightness of the outermost edge of the organic encapsulation layer TFE2 may be secured, as the dam structure DAM has the shape in which the dam patterns DMP1 and DMP2 are spaced apart from each other. Accordingly, in the display device 10, a luminance and a light emission efficiency may be improved by lowering the thickness of the organic encapsulation layer TFE2, and product reliability may be secured by controlling the edge shape of the organic encapsulation layer TFE2.

In an embodiment, an interval between the adjacent first dam patterns DMP1 or an interval between the adjacent second dam patterns DMP2 may be smaller than the spacing between the ink drops. For example, the spacing between the ink drops may have a size of about 100 µm, and the interval DW between the adjacent first dam patterns DMP1 or the interval between the adjacent second dam patterns DMP2 may be 100 µm or less. As the interval DW between the dam patterns DMP1 (DMP2) is formed to be smaller than the spacing between the ink droplets, at least one dam pattern DMP1 (DMP2) may be positioned between adjacent ink droplets, so it is possible to prevent or substantially prevent a curve from being formed at the edge as the ink drops spread.

In an embodiment, the diagonal edge of the display area DAA may have a curved shape instead of a right-angled shape. As illustrated in FIG. 13, in the display area DAA, the edge located in the diagonal direction between the first direction DR1 and the second direction DR2 may have a curved shape instead of a right angle, and accordingly, the first dam DM1 and the second dam DM2 may also have curved outer edges as the dam patterns DMP1 and DMP2 are disposed along the curved edge of the display area DAA. The first dam DM1 may include a plurality of third dam patterns DMP3 disposed to correspond to the curved edge of the display area DAA, and the second dam DM2 may include a plurality of fourth dam patterns DMP4 disposed to correspond to the curved edge of the display area DAA.

The first dam pattern DMP1 and the second dam pattern DMP2 may have a shape in which each of the sides thereof extends in one direction, and a portion where two sides meet may have a right angle. On the other hand, the third dam pattern DMP3 and the fourth dam pattern DMP4 may have a shape in which the lateral sides thereof in the lengthwise direction are curved. The curvature (R value) of the lateral sides of the third dam pattern DMP3 and the fourth dam pattern DMP4 may be equal or substantially equal to the curvature (R value) of the diagonal edge of the organic encapsulation layer TFE2. Because the first dam DM1 and the second dam DM2 include the dam patterns DMP3 and DMP4 having the curved lateral sides to correspond to the shape of the diagonal edge of the display area DAA, the distance from the edge of the display area DAA to the first dam DM1 may be constant or substantially constant regardless of a position. Accordingly, the ink droplets forming the organic encapsulation layer TFE2 may be uniformly or substantially uniformly spread in the area surrounded (e.g., around a periphery thereof) by the first dam DM1.

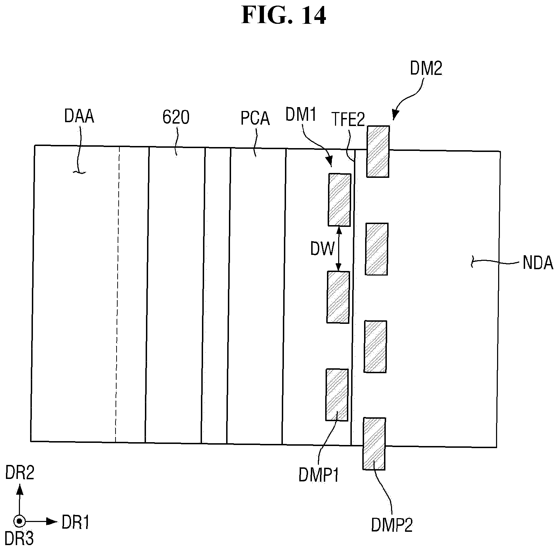

FIG. 14 is a plan view illustrating a schematic disposition of an encapsulation layer and dam structures of a display device according to another embodiment.

Referring to FIG. 14, in the display device 10 according to an embodiment, the first dam patterns DMP1 of the first dam DM1 may not be disposed side by side with the second dam patterns DMP2 of the second dam DM2. The plurality of first dam patterns DMP1 and the plurality of second dam patterns DMP2 may be disposed to be spaced apart from each other in one direction, and an interval DW between the adjacent first dam patterns DMP1 may be equal to or substantially equal to the interval between the adjacent second dam patterns DMP2. However, the first dam pattern DMP1 and the second dam patterns DMP2 forming a pair may be disposed alternately without being disposed side by side with each other, and one second dam pattern DMP2 may be disposed side by side with a space between adjacent first dam patterns DMP1 that are spaced apart from each other.

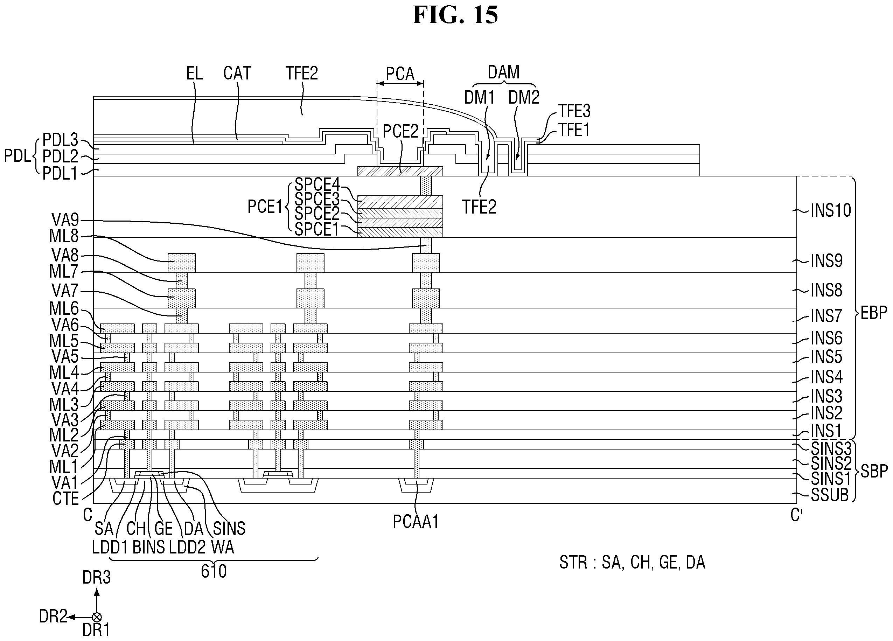

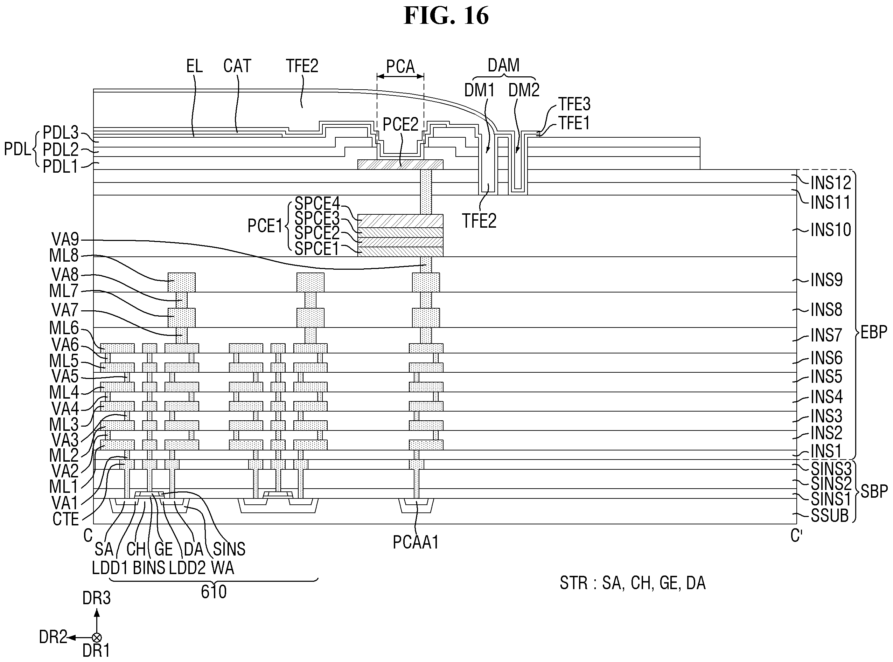

FIGS. 15 and 16 are schematic cross-sectional views illustrating a portion of a display device in which a dam structure is disposed according to one or more embodiments. The dams DM1 and DM2 of the dam structure DAM illustrated in FIGS. 15 and 16 may be substantially a pair of dam patterns DMP1 and DMP2, and FIGS. 15 and 16 may illustrate cross sections crossing the pair of dam patterns DMP1 and DMP2 in the second direction DR2.

Referring to FIG. 15, in the display device 10, the eleventh interlayer insulating film INS11 may be omitted, and each of the first dam DM1 and the second dam DM2 may penetrate the pixel defining film PDL. The depths of the first dam DM1 and the second dam DM2 may be the same or substantially the same as each other, and the bottom surfaces thereof may be the top surface of the tenth interlayer insulating film INS10. The first inorganic encapsulation layer TFE1 may be disposed on the bottom surfaces of the first dam DM1 and the second dam DM2. The organic encapsulation layer TFE2 may be disposed in the first dam DM1, but may not be disposed in the second dam DM2. The second inorganic encapsulation layer TFE3 may be directly disposed on the first inorganic encapsulation layer TFE1. An inorganic junction area in which the first inorganic encapsulation layer TFE1 and the second inorganic encapsulation layer TFE3 are disposed to be in direct contact with each other may be formed at an outer portion of the second dam DM2.

Referring to FIG. 16, the display device 10 may further include a twelfth interlayer insulating film INS12 disposed on the eleventh interlayer insulating film INS11. The twelfth interlayer insulating film INS12 may include the same material as that of the eleventh interlayer insulating film INS11. The twelfth interlayer insulating film INS12 may be disposed to overlap with the first electrode AND in the display area DAA. In the display device 10, as the two interlayer insulating films INS11 and INS12 are disposed, the distance between the first electrode AND and the reflective electrode layer RL may be different between the first to third sub-pixels SP1, SP2, and SP3.

The first dam DM1 and the second dam DM2 of the dam structure DAM may penetrate the pixel defining film PDL, the twelfth interlayer insulating film INS12, and the eleventh interlayer insulating film INS11. The depths of the first dam DM1 and the second dam DM2 may be the same or substantially the same as each other, and the bottom surfaces thereof may be the top surface of the tenth interlayer insulating film INS10. In the first dam DM1 and the second dam DM2, the first inorganic encapsulation layer TFE1 may be in direct contact with the tenth interlayer insulating film INS10, the eleventh interlayer insulating film INS11, the twelfth interlayer insulating film INS12, and the pixel defining film PDL.

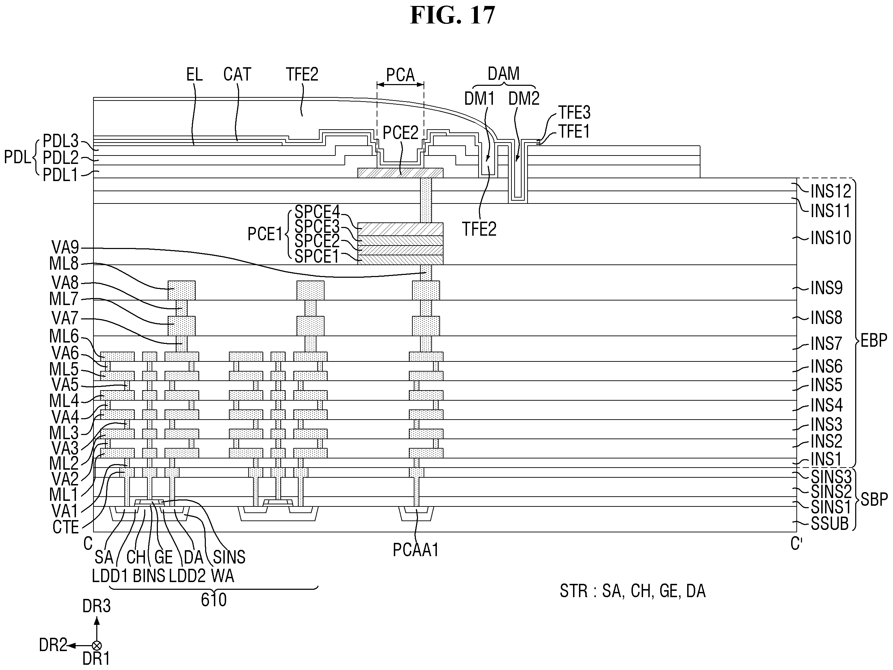

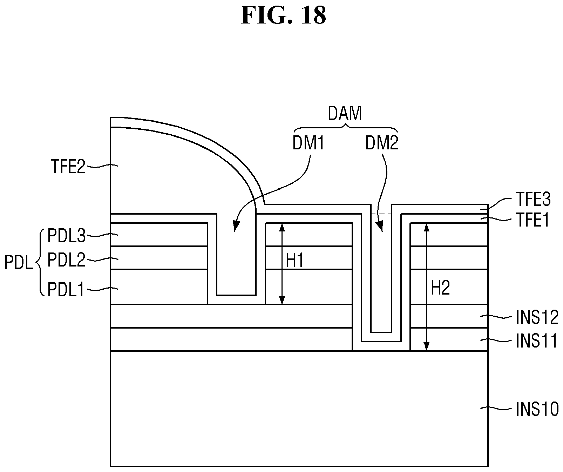

FIG. 17 is a schematic cross-sectional view illustrating a portion of a display device in which a dam structure is disposed according to anther embodiment. FIG. 18 is a cross-sectional view showing dams in more detail of the display device of FIG. 17.

Referring to FIGS. 17 and 18, in the display device 10 according to an embodiment, the first dam DM1 and the second dam DM2 may have different depths H1 and H2 from each other. For example, the display device 10 may include the eleventh interlayer insulating film INS11 and the twelfth interlayer insulating film INS12. The first dam DM1 may penetrate the pixel defining film PDL, but may not penetrate the twelfth interlayer insulating film INS12 and the layers below it. The second dam DM2 may penetrate the pixel defining film PDL, the eleventh interlayer insulating film INS11, and the twelfth interlayer insulating film INS12. A depth H2 of the second dam DM2 may be greater than a depth H1 of the first dam DM1. In the display device 10, the depths of the plurality of dams DM1 and DM2 may increase as they go outwards from the innermost one. As the depth of the dam structure DAM increases as it goes toward the dam (e.g., the second dam DM2) at the outer position, a difference in a volume deviation according to the position of the organic encapsulation layer TFE2 may be offset, and the organic encapsulation layer TFE2 may have a uniform or substantially uniform shape regardless of its position.

The bottom surface of the first dam DM1 may be the top surface of the twelfth interlayer insulating film INS12, and the bottom surface of the second dam DM2 may be the top surface of the tenth interlayer insulating film INS10. The first inorganic encapsulation layer TFE1 may be in contact with the top surface of the twelfth interlayer insulating film INS12 in the first dam DM1, and may be in contact with the top surface of the tenth interlayer insulating film INS10 in the second dam DM2. The organic encapsulation layer TFE2 may be disposed on the first inorganic encapsulation layer TFE1 while filling the first dam DM1. The second inorganic encapsulation layer TFE3 may be directly disposed on the first inorganic encapsulation layer TFE1 in the second dam DM2, and may form an inorganic junction area together with the first inorganic encapsulation layer TFE1 at an outer portion of the second dam DM2.

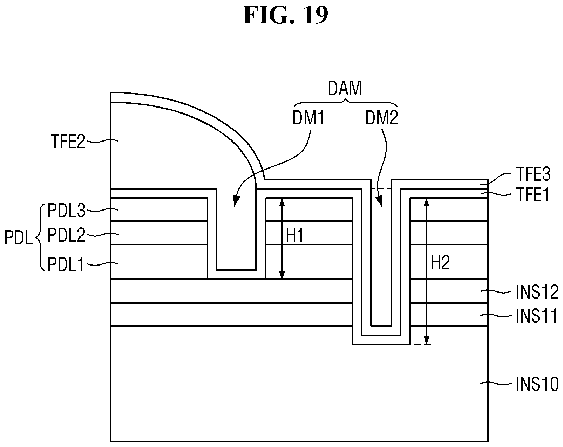

FIG. 19 is a schematic cross-sectional view showing the structure of dams in a display device according to another embodiment.

Referring to FIG. 19, in the display device 10, the second dam DM2 may partially penetrate the tenth interlayer insulating film INS10. The depth H2 of the second dam DM2 may be larger than that illustrated in the embodiment of FIG. 18, and the first inorganic encapsulation layer TFE1 may be in direct contact with a portion of the tenth interlayer insulating film INS10 that is recessed by the second dam DM2. With the increase of the depth of the second dam DM2, which is an outer dam, the display device 10 may more smoothly offset a difference in a volume deviation according to the position of the organic encapsulation layer TFE2.

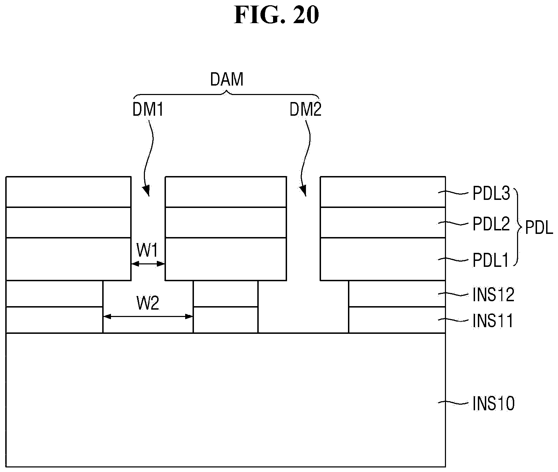

FIGS. 20 through 22 are schematic cross-sectional views of dams of a display device according to one or more embodiments. For convenience of illustration, FIGS. 20 through 22 illustrate schematic shapes of the first dam DM1 and the second dam DM2 of the dam structure DAM, while omitting the illustration of the disposition of the encapsulation layer TFE.

Referring to FIG. 20, in the display device 10 according to an embodiment, each of the first dam DM1 and the second dam DM2 may penetrate the pixel defining film PDL, the twelfth interlayer insulating film INS12, and the eleventh interlayer insulating film INS11. The bottom surfaces of the first dam DM1 and the second dam DM2 may be the top surface of the tenth interlayer insulating film INS10.

In an embodiment, widths W1 and W2 of the first dam DM1 and the second dam DM2 may be partially different. For example, the first width W1 of a portion of the first dam DM1 and the second dam DM2 penetrating the pixel defining film PDL may be smaller than the second width W2 of a portion penetrating the twelfth interlayer insulating film INS12 and the eleventh interlayer insulating film INS11. In the first dam DM1 and the second dam DM2, the inner sidewall of the pixel defining film PDL may further protrude than the inner sidewalls of the twelfth interlayer insulating film INS12 and the eleventh interlayer insulating film INS11. The first dam DM1 and the second dam DM2 may include a tip, or a protruding structure, formed by the pixel defining film PDL, and may prevent or substantially prevent the organic encapsulation layer TFE2 from overflowing beyond the dam structure DAM up to the outer portion of the display device 10, for example, such as to the pad PD.

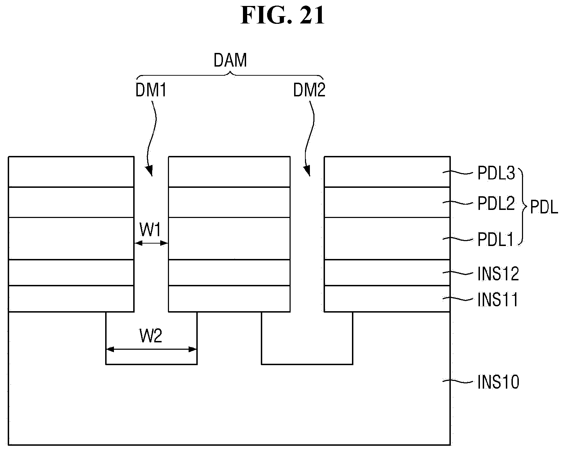

Referring to FIG. 21, in the display device 10 according to an embodiment, the first dam DM1 and the second dam DM2 may be formed so that they penetrate the pixel defining film PDL, the twelfth interlayer insulating film INS12, and the eleventh interlayer insulating film INS11, and such that a portion of the tenth interlayer insulating film INS10 is recessed.

The widths W1 and W2 of the first dam DM1 and the second dam DM2 may be partially different. For example, the first width W1 of the portion of the first dam DM1 and the second dam DM2 penetrating the pixel defining film PDL, the twelfth interlayer insulating film INS12, and the eleventh interlayer insulating film INS11 may be smaller than the second width W2 of the portion thereof formed so that a portion of the top surface of the tenth interlayer insulating film INS10 is recessed. In the first dam DM1 and the second dam DM2, the inner sidewalls of the pixel defining film PDL, the twelfth interlayer insulating film INS12, and the eleventh interlayer insulating film INS11 may further protrude than the inner sidewall of the portion where the top surface of the tenth interlayer insulating film INS10 is recessed. The first dam DM1 and the second dam DM2 may include a tip, or a protruding structure, formed by the pixel defining film PDL, the twelfth interlayer insulating film INS12, and the eleventh interlayer insulating film INS11.

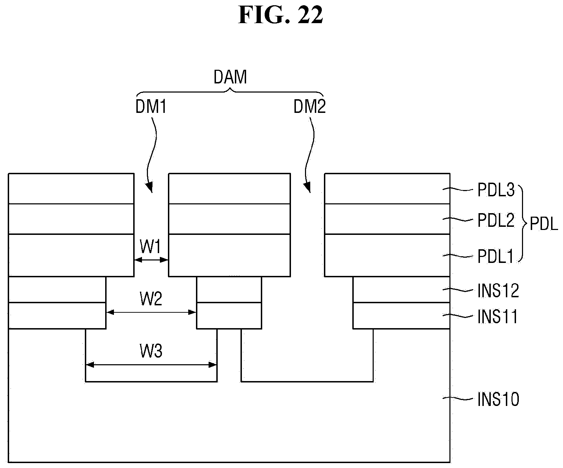

Referring to FIG. 22, the first width W1 of the portion of the first dam DM1 and the second dam DM2 penetrating the pixel defining film PDL may be smaller than the second width W2 of the portion thereof penetrating the twelfth interlayer insulating film INS12 and the eleventh interlayer insulating film INS11 and a third width W3 of a portion thereof formed such that a portion of the top surface of the tenth interlayer insulating film INS10 is recessed. The second width W2 of the portion of the first dam DM1 and the second dam DM2 penetrating the twelfth interlayer insulating film INS12 and the eleventh interlayer insulating film INS11 may be smaller than the third width W3 of the portion thereof formed such that a portion of the top surface of the tenth interlayer insulating film INS10 is recessed. In the first dam DM1 and the second dam DM2, the inner sidewall of the pixel defining film PDL may further protrude inwards than the inner sidewalls of the twelfth interlayer insulating film INS12 and the eleventh interlayer insulating film INS11, and the inner sidewalls of the twelfth interlayer insulating film INS12 and the eleventh interlayer insulating film INS11 may further protrude than the inner sidewall of the portion where the top surface of the tenth interlayer insulating film INS10 is recessed. The first dam DM1 and the second dam DM2 may include a tip, or a protruding structure, formed by the pixel defining film PDL, the twelfth interlayer insulating film INS12, and the eleventh interlayer insulating film INS11.

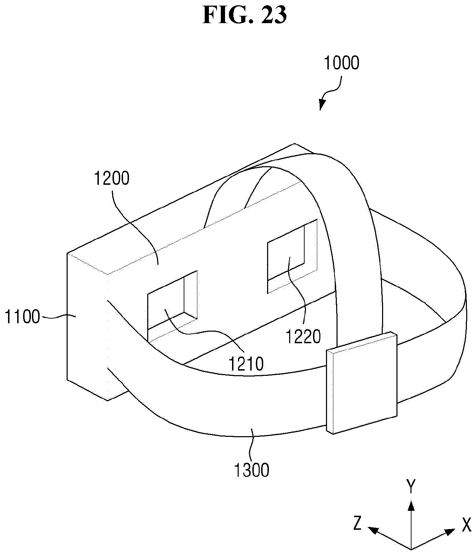

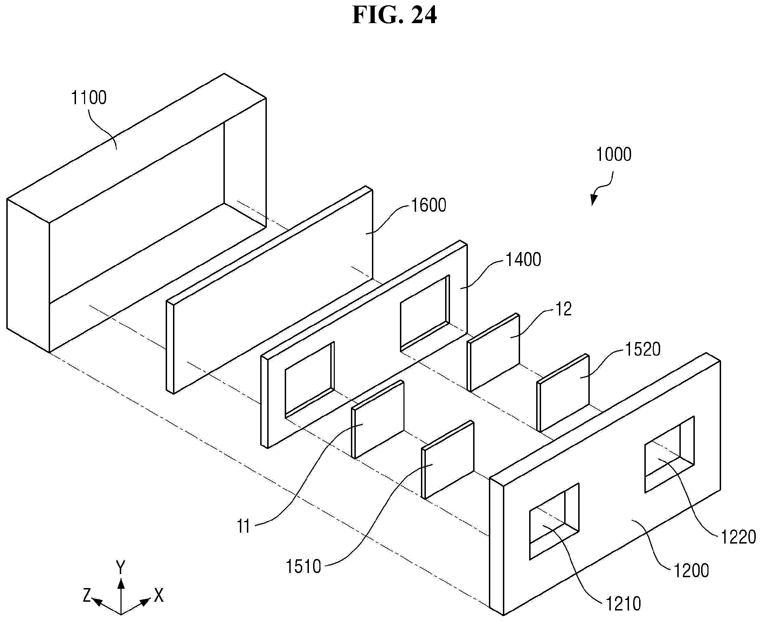

FIG. 23 is a perspective view illustrating a head mounted display device according to an embodiment. FIG. 24 is an exploded perspective view showing an example of the head mounted display device of FIG. 23.

Referring to FIGS. 23 and 24, a head mounted display device 1000 according to an embodiment includes a first display device 11, a second display device 12, a display device housing 1100, a housing cover 1200, a first eyepiece 1210, a second eyepiece 1220, a head mounted band 1300, a middle frame 1400, a first optical member 1510, a second optical member 1520, a control circuit board 1600, and a connector.

The first display device 11 provides an image to a user's left eye, and the second display device 12 provides an image to a user's right eye. Because each of the first display device 11 and the second display device 12 is the same or substantially the same as the display device 10 described above with reference to FIG. 1, redundant descriptions thereof may not be repeated.

The first optical member 1510 may be disposed between the first display device 11 and the first eyepiece 1210. The second optical member 1520 may be disposed between the second display device 12 and the second eyepiece 1220. Each of the first optical member 1510 and the second optical member 1520 may include at least one convex lens.

The middle frame 1400 may be disposed between the first display device 11 and the control circuit board 1600, and between the second display device 12 and the control circuit board 1600. The middle frame 1400 serves to support and fix the first display device 11, the second display device 12, and the control circuit board 1600.

The control circuit board 1600 may be disposed between the middle frame 1400 and the display device housing 1100. The control circuit board 1600 may be connected to the first display device 11 and the second display device 12 through the connector. The control circuit board 1600 may convert an image source input from the outside into the digital video data DATA, and may transmit the digital video data DATA to the first display device 11 and the second display device 12 through the connector.

The control circuit board 1600 may transmit the digital video data DATA corresponding to a left-eye image optimized for the user's left eye to the first display device 11, and may transmit the digital video data DATA corresponding to a right-eye image optimized for the user's right eye to the second display device 12. As another example, the control circuit board 1600 may transmit the same digital video data DATA to the first display device 11 and the second display device 12.

The display device housing 1100 serves to accommodate the first display device 11, the second display device 12, the middle frame 1400, the first optical member 1510, the second optical member 1520, the control circuit board 1600, and the connector. The housing cover 1200 is disposed to cover one open surface of the display device housing 1100. The housing cover 1200 may include the first eyepiece 1210 at which the user's left eye is disposed, and the second eyepiece 1220 at which the user's right eye is disposed. FIGS. 23 and 24 illustrate that the first eyepiece 1210 and the second eyepiece 1220 are disposed separately from each other, but the present disclosure is not limited thereto. The first eyepiece 1210 and the second eyepiece 1220 may be combined together into one.

The first eyepiece 1210 may be aligned with the first display device 11 and the first optical member 1510, and the second eyepiece 1220 may be aligned with the second display device 12 and the second optical member 1520. Accordingly, the user may view the image of the first display device 11 that is magnified as a virtual image by the first optical member 1510 through the first eyepiece 1210, and may view the image of the second display device 12 that is magnified as a virtual image by the second optical member 1520 through the second eyepiece 1220.

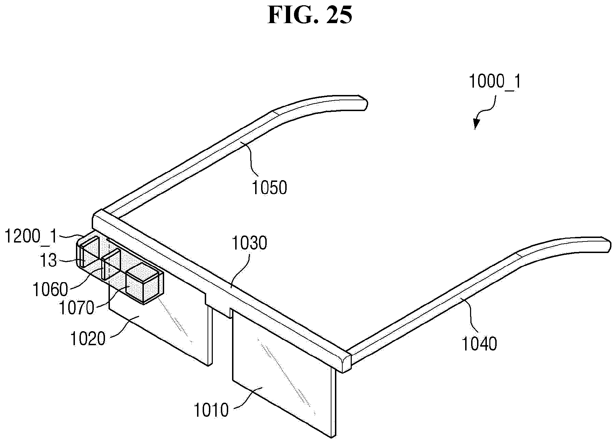

The head mounted band 1300 serves to secure the display device housing 1100 to the user's head, such that the first eyepiece 1210 and the second eyepiece 1220 of the housing cover 1200 remain disposed on the user's left and right eyes, respectively. When the display device housing 1200 is implemented to be lightweight and compact, the head mounted display device 1000 may be provided with, as shown in FIG. 25, an eyeglass frame instead of the head mounted band 1300.

In addition, the head mounted display device 1000 may further include a battery for supplying power, an external memory slot for accommodating an external memory, and an external connection port and wireless communication module for receiving an image source. The external connection port may be a universe serial bus (USB) terminal, a display port, or a high-definition multimedia interface (HDMI) terminal, and the wireless communication module may be a 5G communication module, a 4G communication module, a Wi-Fi module, or a Bluetooth module.

FIG. 25 is a perspective view illustrating a head mounted display device according to an embodiment.

Referring to FIG. 25, a head mounted display device 1000_1 according to an embodiment may be an eyeglasses-type display device in which a display device housing 1200_1 is implemented in a lightweight and compact manner. The head mounted display device 1000_1 according to an embodiment may include a display device 13, a left eye lens 1010, a right eye lens 1020, a support frame 1030, temples 1040 and 1050, an optical member 1060, an optical path changing member 1070, and the display device housing 1200_1.

The display device housing 1200_1 may include the display device 13, the optical member 1060, and the optical path changing member 1070. An image displayed on the display device 13 may be magnified by the optical member 1060, and the optical path may be changed by the optical path changing member 1070 to provide the image to the user's right eye through the right eye lens 1020. As a result, the user may view an augmented reality image, through the right eye, in which a virtual image displayed on the display device 13 and a real image seen through the right eye lens 1020 are combined.

FIG. 25 illustrates that the display device housing 1200_1 is disposed at the right end of the support frame 1030, but the present disclosure is not limited thereto. For example, the display device housing 1200_1 may be disposed on the left end of the support frame 1030, and in this case, the image of the display device 13 may be provided to the user's left eye. As another example, the display device housing 1200_1 may be disposed on both the left and right ends of the support frame 1030, and in this case, the user may view the image displayed on the display device 13 through both the left and right eyes.

The foregoing is illustrative of some embodiments of the present disclosure, and is not to be construed as limiting thereof. Although some embodiments have been described, those skilled in the art will readily appreciate that various modifications are possible in the embodiments without departing from the scope of the present disclosure. It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. Therefore, it is to be understood that the foregoing is illustrative of various example embodiments and is not to be construed as limited to the specific embodiments disclosed herein, and that various modifications to the disclosed embodiments, as well as other example embodiments, are intended to be included within the scope of the present disclosure as defined in the appended claims, and their equivalents.

## Claims

1. A display device comprising:
a substrate comprising a display area, a non-display area around the display area, and a plurality of transistors;
a dam structure in the non-display area;
a light emitting element layer comprising a plurality of light emitting elements in the display area;
an encapsulation layer on the light emitting element layer; and
a cover layer on the encapsulation layer,
wherein the dam structure comprises:
a first dam comprising a plurality of first dam patterns spaced from each other; and
a second dam comprising a plurality of second dam patterns spaced from each other, and
wherein a distance between the second dam and the display area is greater than a distance between the first dam and the display area.

2. The display device of claim 1, wherein the encapsulation layer comprises:
a first inorganic encapsulation layer extending beyond the second dam in the display area and the non-display area;
an organic encapsulation layer on the first inorganic encapsulation layer, and covering the first dam without covering the second dam; and
a second inorganic encapsulation layer on the organic encapsulation layer and the first inorganic encapsulation layer.

3. The display device of claim 2, wherein the first inorganic encapsulation layer and the second inorganic encapsulation layer are in direct contact with each other outside the second dam.

4. The display device of any one of claims 1 to 3, wherein an interval between the first dam patterns that are spaced from each other is 100 µm or less.

5. The display device of any one of claims 1 to 4, wherein a first dam pattern of the first dam patterns and a second dam pattern of the second dam patterns are located side by side with each other, optionally wherein the display area has a curved diagonal edge,
the first dam comprises a plurality of third dam patterns having lateral sides that are curved to correspond to the curved diagonal edge of the display area, and
the second dam comprises a plurality of fourth dam patterns having lateral sides that are curved to correspond to the curved diagonal edge of the display area.

6. The display device of any one of claims 1 to 4, wherein the first dam patterns and the second dam patterns are located alternately with each other, and
a second dam pattern of the second dam patterns is located side by side with an area between adjacent first dam patterns of the first dam patterns.

7. The display device of any one of claims 1 to 6, further comprising a plurality of pads in the non-display area,
wherein the pads are located on an outside of the dam structure without overlapping with the encapsulation layer.

8. A display device comprising:
a substrate comprising a display area, a non-display area around the display area, and a plurality of transistors;
a first insulating film on the substrate;
a pixel defining film on the first insulating film in the display area;
a plurality of light emitting elements corresponding to a plurality of openings in the pixel defining film, respectively;
a dam structure in the non-display area, and comprising a plurality of dams having a trench shape penetrating the pixel defining film;
an encapsulation layer on the light emitting elements in the display area, and covering at least a portion of the plurality of dams; and
a cover layer on the encapsulation layer,
wherein the dam structure comprises an innermost dam that is adjacent to the display area, and an outermost dam outside the innermost dam, and
wherein the encapsulation layer comprises an organic encapsulation layer covering at least the innermost dam without overlapping with the outermost dam from among the plurality of dams, and covering the light emitting elements.

9. The display device of claim 8, wherein the plurality of dams have the same depth as each other, optionally further comprising a second insulating film between the pixel defining film and the first insulating film,
wherein each of the plurality of dams penetrates the pixel defining film and the second insulating film, further optionally further comprising a third insulating film between the pixel defining film and the second insulating film,
wherein each of the plurality of dams penetrates the pixel defining film, the third insulating film, and the second insulating film.

10. The display device of claim 8, wherein a depth of the outermost dam among the plurality of dams is greater than a depth of the innermost dam among the plurality of dams, optionally further comprising a second insulating film and a third insulating film between the pixel defining film and the first insulating film,
wherein the innermost dam penetrates the pixel defining film, and
wherein the outermost dam penetrates the pixel defining film, the second insulating film, and the third insulating film, further optionally wherein the outermost dam comprises a recessed portion of a top surface of the first insulating film.

11. The display device of claim 8, further comprising a second insulating film and a third insulating film between the pixel defining film and the first insulating film,
wherein the plurality of dams penetrate the pixel defining film, the second insulating film, and the third insulating film, and have widths that increase in a downward direction.

12. The display device of claim 11, wherein:
(i) a width of a portion in the plurality of dams penetrating the pixel defining film is smaller than a width of a portion in the plurality of dams penetrating the second insulating film and the third insulating film; or
(ii) the plurality of dams comprises a recessed portion of a top surface of the first insulating film, and
a width of a portion in the plurality of dams penetrating the pixel defining film, the second insulating film, and the third insulating film is smaller than a width of a portion in the plurality of dams comprising the recessed portion of the top surface of the first insulating film, optionally wherein a width of a portion in the plurality of dams penetrating the second insulating film and the third insulating film is smaller than the width of the portion in the plurality of dams comprising the recessed portion of the first insulating film.

13. The display device of any one of claims 8 to 12, wherein the encapsulation layer comprises a first inorganic encapsulation layer and a second inorganic encapsulation layer stacked on each other with the organic encapsulation layer interposed therebetween, and
the first inorganic encapsulation layer and the second inorganic encapsulation layer are in direct contact with each other outside the outermost dam of the dam structure.

14. A head mounted display device comprising:
a frame configured to be mounted on a user's body to correspond to left and right eyes of the user;
a plurality of display devices in the frame; and
an eyepiece on each of the plurality of display devices,
wherein each of the display devices comprises:
a substrate comprising a display area, a non-display area around the display area, and a plurality of transistors;
a dam structure in the non-display area;
a light emitting element layer comprising a plurality of light emitting elements in the display area;
an encapsulation layer on the light emitting element layer; and
a cover layer on the encapsulation layer,
wherein the dam structure comprises:
a first dam comprising a plurality of first dam patterns spaced from each other; and
a second dam comprising a plurality of second dam patterns spaced from each other, the second dam having a trench shape and located at a greater distance from the display area than the first dam, and
wherein the encapsulation layer comprises an organic encapsulation layer covering the first dam without overlapping with the second dam, and covering the light emitting elements.

15. The head mounted display device of claim 14, wherein:
(i) the first dam and the second dam have the same depth as each other; or
(ii) a depth of the second dam is greater than a depth of the first dam.
